# EUROPEAN PATENT SPECIFICATION

(11) **EP 0 849 663 B1**
(45) Date of publication and mention of the grant of the patent: **19.11.2003**
(21) Application number: 97310722.0
(22) Date of filing: 18.12.1997
(51) Int. Cl.: G06F 7/50, G06F 7/52

(54) **Conditional sum adder using pass-transistor logic**
Addierer mit bedingter Summe unter Benutzung von Durchlasstransistor-Logik
Additionneur à somme conditionnelle utilisant la logique à transisteur de passage

(30) Priority: 18.12.1996 KR 9667478
(43) Date of publication of application: 24.06.1998
(73) Proprietor: Samsung Electronics Co., Ltd., Suwon-city, Kyungki-do (KR)
(72) Inventor: Song, Min-Kyu, Eunpyung-ku, Seoul (KR)
(74) Representative: Tunstall, Christopher Stephen

(56) References cited:
- EP-A- 0 113 391
- EP-A- 0 214 836
- EP-A- 0 334 768
- EP-A- 0 394 610
- EP-A- 0 450 752
- US-A- 5 163 020
- US-A- 5 347 482
- KWAN H ET AL: "A NEW DESIGN FOR A LOOKAHEAD CARRY GENERATOR" ASILOMAR CONFERENCE ON SIGNALS, SYSTEMS AND COMPUTERS, PACIFIC GROVE, 30 OCT. - 2 NOV. 1994, vol. 2, no. CONF. 28, 1994, pages 1393-1397, XP000533872
- NORIO OHKUBO ET AL: "A 4.4-NS CMOS 54X54-B MULTIPLIER USING PASS-TRANSISTOR MULTIPLEXER" PROCEEDINGS OF THE CUSTOM INTEGRATED CIRCUITS CONFERENCE, SAN DIEGO, MAY 1 - 4, 1994, no. CONF. 16, 1 May 1994, pages 599-602, XP000492961 INSTITUTE OF ELECTRICAL AND ELECTRONICS ENGINEERS
- HIROYUKI MORINAKA ET AL: "A 64BIT CARRY LOOK-AHEAD CMOS ADDER USING MODIFIED CARRY SELECT" PROCEEDINGS OF THE CUSTOM INTEGRATED CIRCUITS CONFERENCE, SANTA CLARA, 1-4 MAY 1995, no. CONF. 17, pages 585-588, XP000536873
- AJAY NAINI ET AL: "A 4.5 NS 96B CMOS ADDER DESIGN" PROCEEDINGS OF THE CUSTOM INTEGRATED CIRCUITS CONFERENCE, BOSTON, MAY 3 - 6, 1992, no. CONF. 14, 3 May 1992, pages 25.5.1-25.5.4, XP000340958 INSTITUTE OF ELECTRICAL AND ELECTRONICS ENGINEERS
- SONG P J ET AL: "CIRCUIT AND ARCHITECTURE TRADE-OFFS FOR HIGH-SPEED MULTIPLICATION" IEEE JOURNAL OF SOLID-STATE CIRCUITS, vol. 26, no. 9, 1 September 1991, pages 1184-1198, XP000262814

## Description

The present invention relates to integrated pass-transistor logic circuits, and more particularly to a conditional sum adder (CSA) using pass-transistor logic (PL) and an integrated circuit embodying the same

Maj or aims of circuit designs are to develop integrated circuits having a higher speed, smaller size and lower power consumption. CMOS (Complementary Metal Oxide Semiconductor) circuit has lower power consumption and more enhanced performance in its characteristics, as compared with NMOS (N-type MOS), PMOS (P-type MOS), or bipolar circuits. CMOS design technology serves as a major technology in designing complex monolithic systems having high dense logic,low power dissipation, low supply voltage and highly automated synthesis.

CMOS static logic circuits, however, may be frequently operated in a manner that PMOS and NMOS transistors constituting a CMOS invertor are simultaneously turned on. Since this leads to the occurrence of large leakage current in the CMOS invertor, such CMOS static logic circuits are not suitable to be operated at high speed and with low power. Therefore, in high speed and low power applications, either operation speed or low power should be selected to consider CMOS design. Alternatively, a balance of both the low power and operation speed is required to design CMOS devices. This limits the design flexibility of the CMOS design.

In several applications, pass-transistor logic (PL) circuits have been used to largely reduce circuit size without the increase in power and the reduction of operation speed. Introduction of such PL circuits allows to minimise trade-offs as stated above.

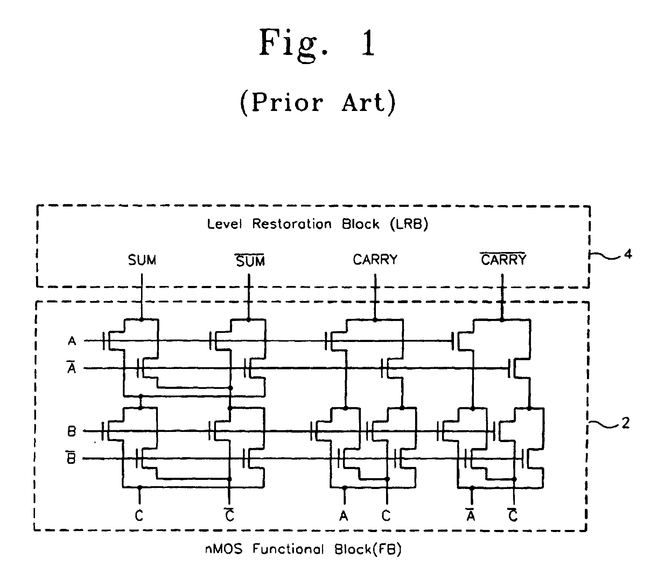

Fig. 1 shows a 3-bit full adder as an example of the prior art PL circuit. Other prior art adder circuitry is disclosed in EP 0450752. This discloses a high speed adder including two independent adders and a means for producing carries for both adders. KWAN H et al 'A new design for lookahead carry generator' Asilomar conference on signals, systems and computers, Pacific Grove 30 Oct - 2 Nov 1994 Vol 2 No. Conf. 28 1994 pages 1393-1397, XP000533872 also discloses adder circuitry. In particular a new design for a lookahead carry generator is disclosed. NORIO O et al: 'A 4.4 - NS CMOS 54 x 54 ― B Multiplier Using Pass-Transistor Multiplexer' Proceedings of the Custom Integrated Circuits Conference, San Diego, May 1 ― 4 1994, No. Conf. 16, 1 May 1994, pages 599 - 602, XP000492861 discloses a carry lookahead adder in which pass-transistor multiplexers are employed.

As shown in Fig. 1 the three bit full adder noted above has a functional block (FB) 2 and a level restoration block (LRB) 4. The functional block 2 is constituted with only NMOS transistors so as to operate at high speed and with low power and to reduce its chip area, and performs addition operation of three input signals A, B, C to provide a sum signal SUM, a carry signal CARRY, and complementary signals $\overline{\text{SUM}}$ and $\overline{\text{CARRY}}$ thereof. The level restoration block 4 is provided to restore a signal of weak high level provided from the functional block 2 to a signal V_{DD} of strong or full high level. The weak high level signal has V_{DD} ― V_{TN} , where V_{TN} represents the threshold voltage of the NMOS transistor.

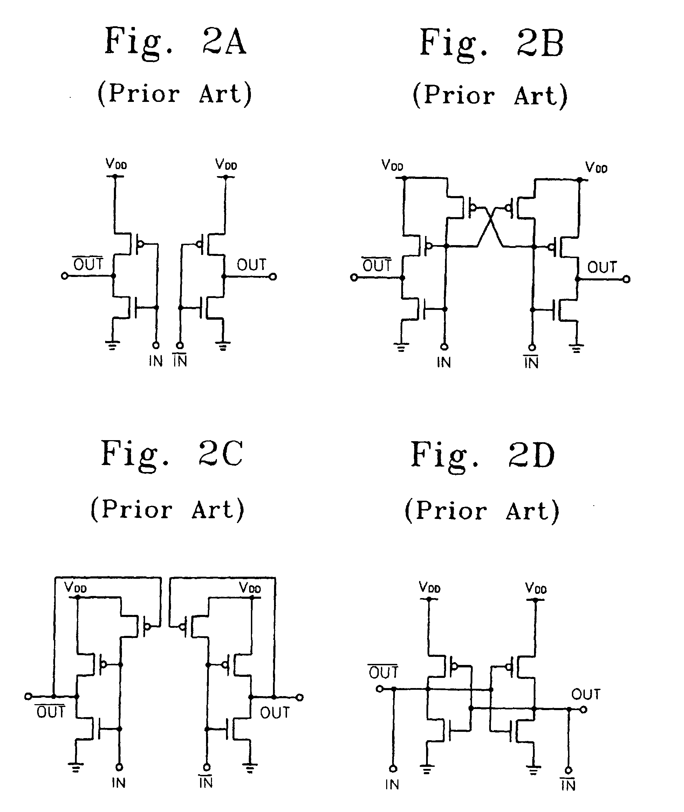

Prior art level restoration circuits are illustrated in Figs. 2A through 2D. The circuit of Fig. 2A is a level restoration circuit which is used in a complementary pass-transistor logic (CPL). Level restoration block of the CPL is constituted with CMOS invertors.

In this CPL level restoration block, for example, when a strong or full low level signal (i.e. ground level signal Vss) is applied to an input terminal IN thereof, PMOS transistor of the first invertor is made conductive. The strong high level signal V_{DD} is then outputted from an output terminal of the level restoration block (ie the output terminal $\overline{\text{OUT}}$ of the first invertor). When a weak high level signal V_{DD}-V_{TN} is applied to the other input terminal $\overline{\text{IN}}$ of the level restoration block, NMOS transistor of the second invertor is made conductive so that the weak high level signal is outputted from the other output terminal of the level restoration block (ie the output terminal OUT of the second invertor). This phenomenon is generated because the PMOS transistor of the second invertor is not completely turned off due to the weak high level signal V_{DD}-V_{TN}. Therefore, since the PMOS transistor is not completely turned off, little amount of leakage current normally flows through the PMOS transistor, and thereby the operation speed of the CPL level restoration block can be higher, but the power consumption thereof be increased.

So as to solve the above mentioned problems of the CPL level restoration block, several circuits such as PMOS latched type CPL, standalone type and SRPL (swing restored pass-transistor logic) level restoration circuits, as shown in FIGs. 2B to 2D, have been proposed. Of these improved level restoration circuits, particularly the SRPL level restoration circuit is constituted with only CMOS invertors similarly to the CPL level restoration circuit of FIG. 2A. However, one input terminal IN of the level restoration block is commonly connected to the output terminal $\overline{\text{OUT}}$ of the first invertor, and the input terminal of the second invertor, and the other input terminal $\overline{\text{IN}}$ thereof is commonly connected to the output terminal OUT of the second invertor and the input terminal of the first invertor.

In such SRPL level restoration circuit, for example, when a weak high level signal V_{DD}-V_{TN} from the functional block 2 is applied to the input terminal thereof, the weak high level signal is outputted via one output terminal ( ie an output terminal $\overline{\text{OUT}}$ of the first invertor) of the level restoration circuit. The weak high level signal is also applied to the input terminal of the second invertor, and thereby the NMOS transistor of the second invertor is turned on. The other terminal of the level restoration block (ie the output terminal OUT of the second invertor) is then at a strong low level signal, so that the PMOS transistor of the second invertor is completely turned off . As a result, no leakage current flows through the PMOS transistor.

However, the SRPL level restoration circuit is excellent in restoring a weak high level signal to V_{DD} level, but the output voltage thereof is discharged through the NMOS transistors of the functional block 2. In logic circuit in which cascaded NMOS transistors are connected in series like a full adder, the discharging time is largely lengthened. This leads to the increase in delay time.

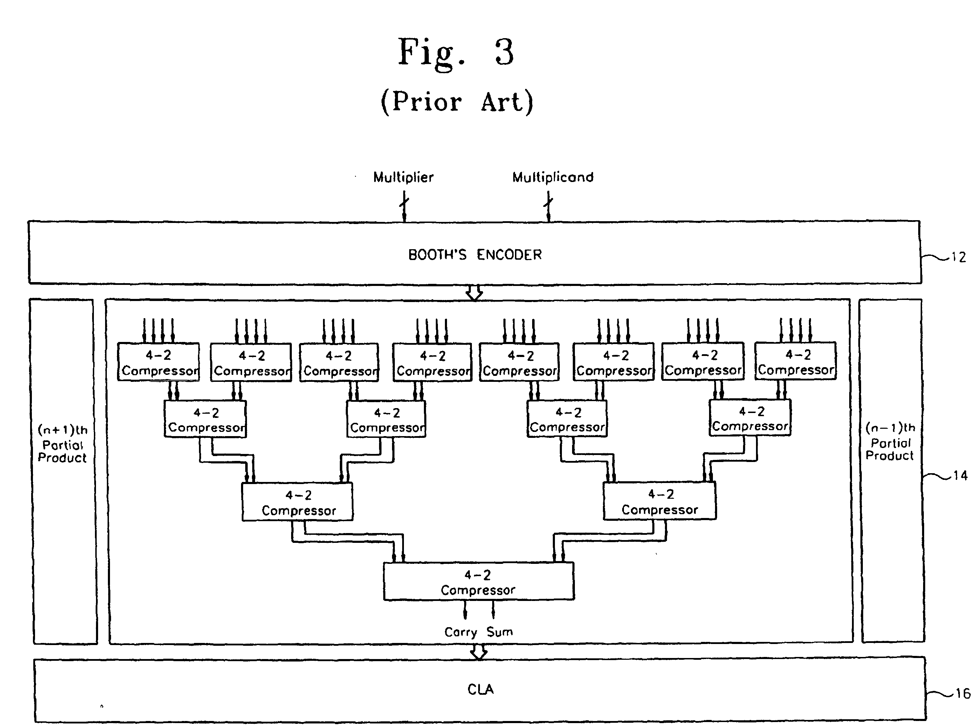

It is indispensable to improve floating-point operation functions in high performance microprocessors having operational frequency of about 200 MHZ or more. With the increase in demand of multimedia applications, the importance of high speed multiplication is increased in reduced instruction set computer (RISC), digital signal processor (DSP), graphics accelerators or the like. On demand, high speed (54x54)-bit multiplier has been disclosed in IEEE Journal of Solid-State Circuits entitled "A 4.4ns CMOS 54x54-b Multiplier Using Pass-Transistor Multiplexer", Vol. 30, No.3, pp 251-257, March, 1995. The multiplier structure is shown in FIG. 3.

Referring to FIG. 3, the multiplier is constructed using Booth's algorithm and Wallace's tree. The multiplier has a Wallace's tree compressor 14 which is constituted with a modified Booth's encoder (MBE) 12 and a number of 4-to-2 compressors, and a 108-bit conditional sum adder (CSA) 16. This adder 16 is called a conditional carry selection adder or a carry lookahead adder. The Wallace's tree compressor 14 is constituted with fifty-four compression units. Fifty - four vertical data signals from the modified Booth's encoder 12 are provided to the fifty-four compression units, respectively. Each vertical data signal which has 32-bit partial product is finally compressed to a 1-bit carry signal and a 1-bit sum signal by means of a corresponding compression unit. Finally obtained carry and sum signals provided by each compression unit has the same delay time with respect to respective compression units. The finally obtained carry and sum signals from the compressor 14 are provided to the 108-bit conditional sum adder 16. This sum adder 16 generates the final data signal of the (54x54)-bit multiplier.

Since the above stated multiplier has an encoder to which Booth's algorithm is implemented so as to produce vertical data signals, however, hardware structure of the multiplier is complicated.

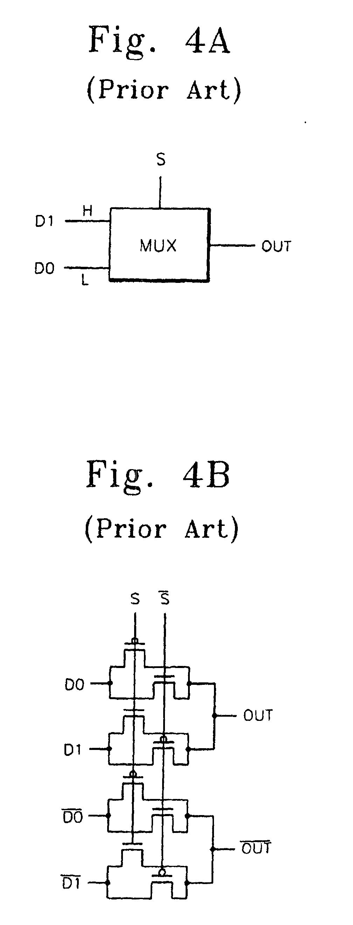

FIG. 4A shows a pass-transistor multiplexer which is used in both the 4-to-2 compressor and the 108-bit conditional sum adder, and FIG. 4B is a detailed circuit diagram of the pass-transistor multiplexer of FIG. 4A. In this multiplexer of FIG. 4B, when a control signal S is at low level, a data signal D0 is selected. When the control signal S is at high level, a data signal D1 is selected. The output signal of the multiplexer is used as an input signal of a next stage multiplexer.

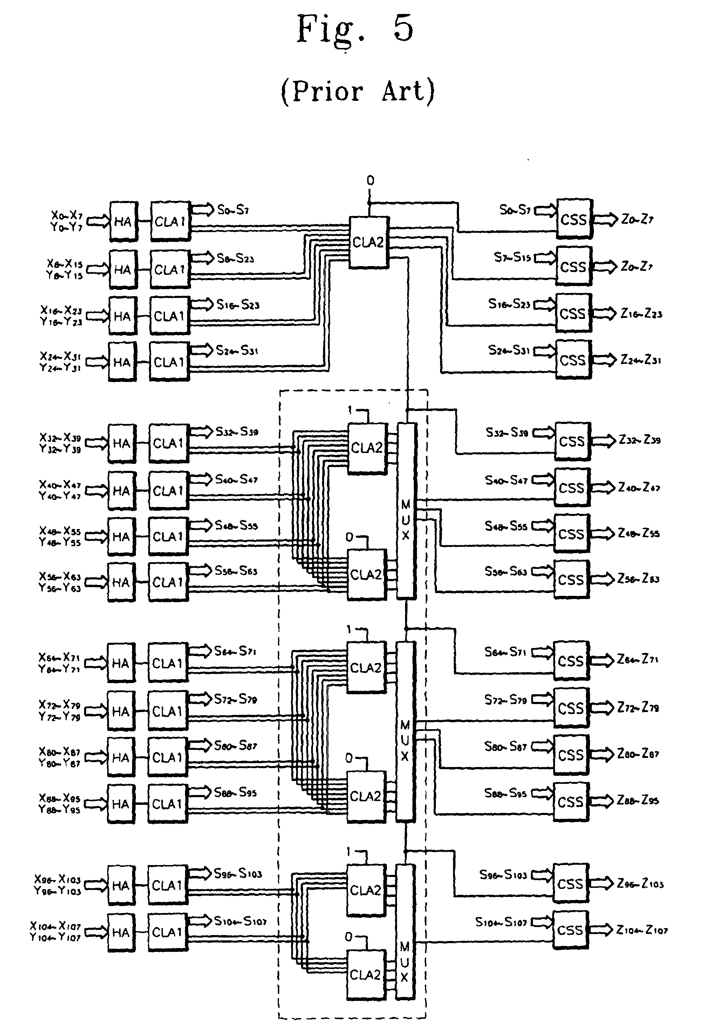

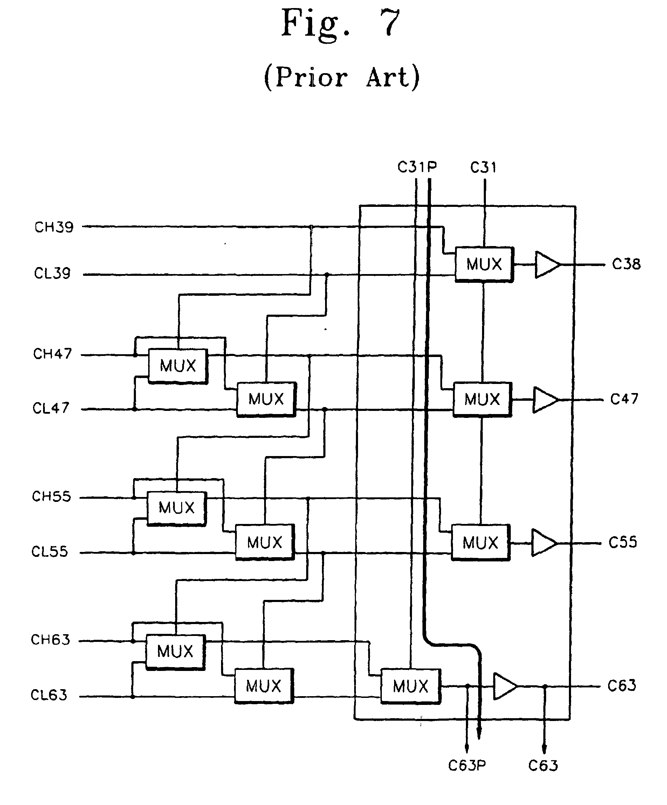

FIG. 5 shows the 108-bit conditional sum adder of FIG. 3. In FIG. 5, the prior art 108-bit conditional sum adder has fourteen half adder blocks (HA), a first group of first carry lookahead adder blocks (CLA1's), a second group of second carry lookahead blocks (CLA2's), three multiplexers (MUX's) and fourteen conditional sum selection blocks (CSS's). The first group of first carry lookahead adder blocks has fourteen carry lookahead adder blocks and the second group of second carry lookahead adder blocks has seven carry lookahead adder blocks. One half-adder (HA) and one (CLA1) of the first carry lookahead adder blocks constitute one 8-bit moduled conditional carry selection block. One example of the second carry lookahead adder blocks is shown in Fig 7.

Turning to FIG. 5, in the 108-bit conditional sum adder, a delay time caused by one multiplexer is t_{MUX}, a time interval between the input and output signals of the conditional sum adder, namely the delay time of all multiplexers is 12t_{MUX}· In detail, each input signal of the conditional sum adder is delayed by t_{MUX} by means of the half-adder, by 4t_{MUX} by means of the first lookahead adder block CLA1, by 3t_{MUX} by means of the second lookahead adder block CLA2, by 3t_{MUX} by means of the serially connected three multiplexers, and by t_{MUX} by means of the conditional sum selection block CSS.

Critical path as stated above is caused by simultaneously generating the sum signal and the carry signal. Since carry propagation time is lazy in comparison with sum propagation time, the operation speed of the conditional sum adder is consequently determined by the carry propagation signal.

In addition, however fast the propagation of the sum signal just before the final output stage is, since the carry and the sum signals in the prior art conditional sum adder must be propagated to a next stage multiplexer, a final output signal is outputted after delayed by t_{MUX} from the propagation completion of the final carry signal.

It is an aim of embodiments of the present invention to at least partly mitigate the above - referenced problems.

According to a first aspect of the present invention there is provided an N-bit conditional sum adder as defined in independent claim 1.

According to a second aspect of the present invention there is provided an integrated pass-transistor logic circuit comprising an encoding means for receiving a first N/2-bit data signal and generating first to an (N/2)-th N/2-bit parallel data signal;
a compressing means for receiving the first to (N/2)-th parallel data signals and compressing each of the parallel data signals to a 2-bit signal to generate an N/2-bit sum signal and an N/2-bit carry signal; and
an adding means for the N/2-bit sum signal and the N/2-bit carry signal from the compressing means; wherein the encoding means generates the second N/2-bit data signal as a corresponding vertical data signal when a bit value of the first N/2-bit data signal is logic "1" and generates a vertical data signal of logic "0" when a bit value of the first N/2-bit data signal is logic "0"; and the adding means comprising an N-bit conditional sum adder according to any one of claims 1-7.

Further embodiments of the invention are specified in the appended dependent claims.

Embodiments of the present invention provide a conditional sum adder which has an improved operation speed.

Embodiments of the present invention provide a conditional sum adder which is operated with low power consumption.

Embodiments of the present invention provide a conditional sum adder to allow an operation speed thereof to be determined by a sum propagation signal.

Embodiments of the present invention provide a carry generation circuit which has carry propagation faster than sum propagation in the conditional sum adder.

Embodiments of the present invention provide a (54x54)-bit multiplier having a high-speed conditional sum adder and a compressor in which an encoder for directly compressing an input data signal is provided without the use of Booth's encoder.

Embodiments of the present invention to provide an energy economised pass-transistor logic circuit which has high-speed operation characteristics in a small chip area thereof.

Embodiments of the present invention will now be described by way of example only with reference to the accompanying drawings in which:
FIG. 1 is a circuit diagram showing the construction of a typical 3-bit full adder having a pass-transistor logic;
FIGs. 2A through 2D are detailed circuit diagrams of prior art level restoration circuits;
FIG. 3 is a block diagram of a (54X54)-bit multiplier in which a prior art 108-bit conditional sum adder using pass-transistor multiplexers is provided;
FIG. 4A is a block diagram of the pave-transistor multiplexer;
FIG. 4B is a circuit diagram of the pass-transistor multiplexer shown in FIG. 4A;
FIG. 5 is a block diagram showing the construction of the 108-bit conditional sum adder shown in FIG. 3;

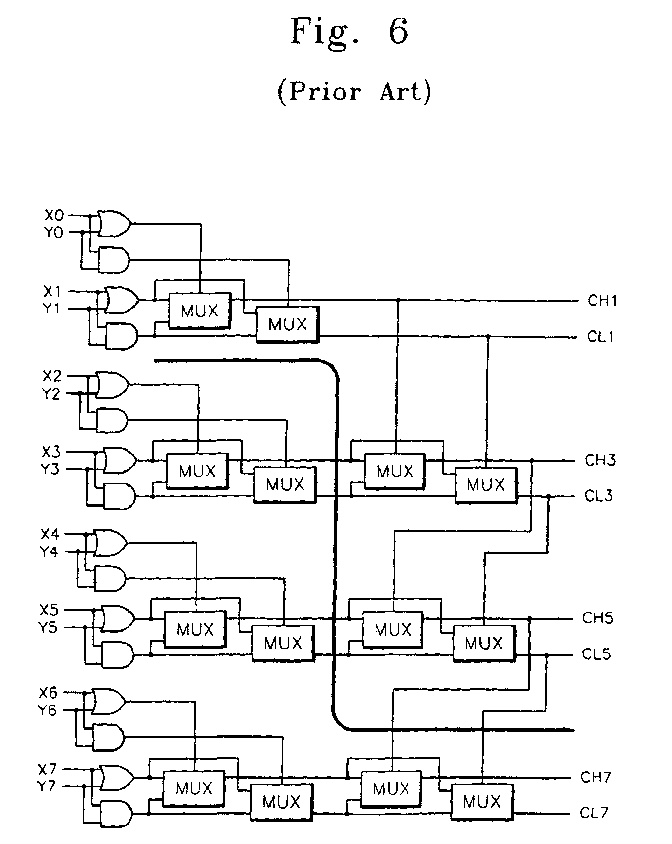

FIG. 6 is a block diagram showing the construction of an 8-bit conditional carry selection block which is constituted with the half-adder and first carry lookahead adder shown in FIG. 5;
FIG. 7 is a block diagram showing the construction of the second carry lookahead adder shown in FIG. 5;
FIG. 8 is a detailed circuit diagram of a level restoration circuit according to a preferred embodiment of the present invention;
FIG. 9 is a circuit diagram showing the construction of a 1-bit full adder according to the present invention;
FIG. 10A is a block diagram showing an ideal simulation environment of the full adder;
FIG. 10B is a waveform diagram of input and output signals of the full adder shown in FIG. 10A;
FIG. 11 is a block diagram showing the simulation environment of a cascade full adder chain;
FIG. 12 is a graph diagram showing an average delay characteristic of respective pass-transistor logics in the full adder chain shown in FIG. 11;
FIG. 13 is a graph diagram showing a power consumption characteristic of respective pass-transistor logics in the full adder chain shown in FIG. 11;
FIG. 14 is a graph diagram showing transition current processes of the pass-transistor logic of the prior art and the pass-transistor logic according to the present invention;
FIG. 15 is a graph diagram showing power (P)^{x}delay (D) characteristic of the respective pass-transistor logic in the full adder chain shown in FIG. 11;
FIG. 16 is a block diagram of a (54^{x}54)-bit multiplier in which the 108-bit conditional sum adder according to the present invention can be provided;
FIG. 17 is a block diagram of the 9-to-2 compressor shown in FIG. 16;
FIG. 18 is a block diagram of the 6-to-2 compressor shown in FIG. 16;
FIG. 19 is a block diagram of the 4-to-2 compressor shown in FIG. 16;
FIG. 20 is a circuit diagram of the compression unit shown in FIG. 16;
FIG. 21 is a diagram showing simulation results of a threshold path in the compression unit shown in FIG. 20;
FIG. 22 is a block diagram of the 108-bit conditional sum adder circuit of FIG. 16 according to a preferred embodiment of the present invention;
FIG. 23 is a detailed circuit diagram of the pre-carry & pre-sum generator in the 16-bit moduled sum generation block shown in FIG. 22;
FIG. 24 is a detailed circuit diagram of the sum generator in the 16-bit moduled sum generation block shown in FIG. 22;
FIG. 25A is a detailed circuit diagram of the multiplexer having a single input;
FIG. 25B is a detailed circuit diagram of the multiplexer having a single input and a revel restoration block;
FIG. 25C is a detailed circuit diagram of the multiplexer having duplex inputs;
FIG. 25D is a detailed circuit diagram of the multiplexer having duplex inputs and a level restoration block;
FIG. 26 is a graph showing a delay characteristic of the multiplexer according to fan-out thereof;
FIG. 27 is a block diagram showing the construction of the carry generation block shown in FIG. 22;
FIG. 28A is a detailed diagram of the group carry generation section in the first carry lookahead adder of FIG. 27;
FIG. 28B is a detailed diagram of the group carry propagation section in the first carry lookahead adder of FIG. 27;
FIG. 29 is a detailed diagram of the second carry lookahead adder shown in FIG. 27;
FIG. 30 is. a timing diagram showing the simulation results of the 108-bit conditional sum adder according to the present invention; and
FIG. 31 is a diagram showing multiplication times of the multiplier of the prior art and the multiplier of FIG. 16.

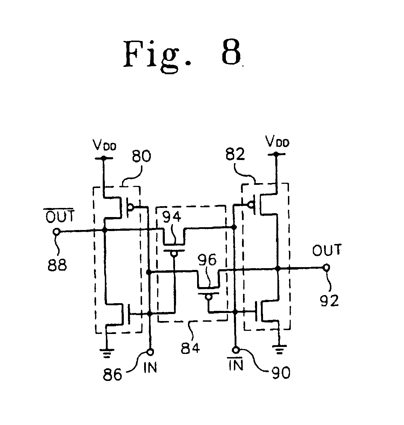

FIG. 8 shows a level restoration circuit of EEPL (energy economised pass transistor logic) which may be used in a preferred embodiment of the present invention.

Referring to FIG. 8, the level restoration circuit has two CMOS invertors 80 and 84 (hereinafter, referred to as "first invertor" and "second invertor", respectively), and a regenerative feedback generator 84 which is connected between the input and output of the first and second invertors 80 and 82. The regenerative feedback generator 84 is constituted with two PMOS transistors 94 and 96. The PMOS transistor 94 has a gate which is connected to a first input 86 (ie, the input of the first invertor 80), and a current path which is connected between a first output 88 (ie, the output of the first invertor 80) and a second input 90 (ie, the input of the second invertor 82). The PMOS transistor 96 has a gate which is connected to the second input 90, and a current path which is connected between the first input 86 and a second output 92 (ie, the output of the second invertor 82). The current path of each PMOS transistor is also called a source-drain channel.

In the level restoration circuit of FIG. 8, when an input signal IN of low level is applied to the first input 86, a complementary signal $\overline{\text{IN}}$ of the input signal IN must be at high level. On the contrary, when the input signal IN is at high level, the complementary signal $\overline{\text{IN}}$ must be at low level. It can be previously understood from FIG. 1 that a high level signal provided from NMOS functional block 2 is a weak high level signal (V_{DD}-V_{TN}), as mentioned above.

Turning again to FIG. 8, if the first input signal IN is a weak high level signal (V_{DD}-V_{TN}), the second input signal $\overline{\text{IN}}$ as being a complementary signal thereof is at strong low level V_{SS} and thereby the PMOS transistor of the second invertor 82 is completely turned on. The second output 92 is then at strong high level V_{DD}, and the PMOS transistor 96 of the generative feedback generator 84 is made conductive by the second input signal $\overline{\text{IN}}$ of strong low level. As a result, the second output signal OUT having strong high level V_{DD} is applied to the first invertor 80 as a positive feedback signal. Therefore, the PMOS transistor of the first invertor 80 is completely turned off (or, made nonconductive) so that no leakage current flows through the PMOS transistor. Also, the NMOS transistor of the first invertor 80 is completely turned on (or, made conductive) so that the first output 88 is at strong low level V_{SS}.

On the contrary, when the second input signal $\overline{\text{IN}}$ is a weak high level signal (V_{DD}-V_{TN}), the first input signal IN as being a complementary signal thereof is at strong low level V_{SS} and thereby the PMOS transistor of the first invertor 80 is completely turned on. The first output 88 is then at strong high level V_{DD} and the PMOS transistor 94 of the generative feedback generator 84 is made conductive by the first input signal IN of strong low level. As a result, the first output signal $\overline{\text{OUT}}$ having strong high level V_{DD} is applied to the second invertor 82 as a positive feedback signal. Therefore, the PMOS transistor of the second invertor 82 is completely turned off so that no leakage current flows through the PMOS transistor. Also, the NMOS transistor of the second invertor 82 is completely turned on so that the second output 92 is at strong low level V_{SS}.

As shown in FIG. 8, since the level restoration circuit according to the present invention further has two PMOS transistors 94 and 96 constituting the regenerative feedback generator 84 in comparison with the prior art level restoration circuit FIG. 2A, it may be some increased in chip area. But, the chip area of the level restoration circuit can be largely reduced because the two PMOS transistors 94 and 96 are used for switching.

According to the following table 1, it can be seen that the lay-out size of the level restoration circuit is some larger than that of the prior art CPL (complementary pass-transistor logic), and nearly the same as that of another prior art CPL2. The table 1 shows characteristics of full adders with level restoration circuits to which the prior art and the present invention are implemented under the conditions that 0.6µm CMOS technique is applied to fabricate the same, a source power V_{SS} is set to 3.3V, and a load capacitance C_{L} is set to 30fF.

**[Table 1]**

| | Number of Transistors | Relative Chip Area | Delay [ns] | Power [mW/25MHz] | Power^{X} Delay [pJ] | Relative Energy Consumption | Area^{X}Energy Consumption |
|---|---|---|---|---|---|---|---|
| CPL (m=1) | 28 | 100 | 1.00 | 0.356 | 0.358 | 100.0 | 100.0 |
| CPL2 (m=1) | 32 | 109 | 0.74 | 0.266 | 0.197 | 40.7 | 44.4 |
| Stand (m=1) | 32 | 109 | 1.08 | 0.297 | 0.321 | 97.0 | 105.8 |
| SRPL (m=3) | 28 | 758 | 0.56 | 0.496 | 0.278 | 43.6 | 330.5 |
| EEPL (m=1) | 32 | 109 | 0.85 | 0.233 | 0.198 | 46.9 | 51.1 |

In the above table 1, m indicates a relative ratio of width(W)/length(L) of NMOS functional block, m=1 does 1.7/0.6 and m=3 does 5.1/0.65.

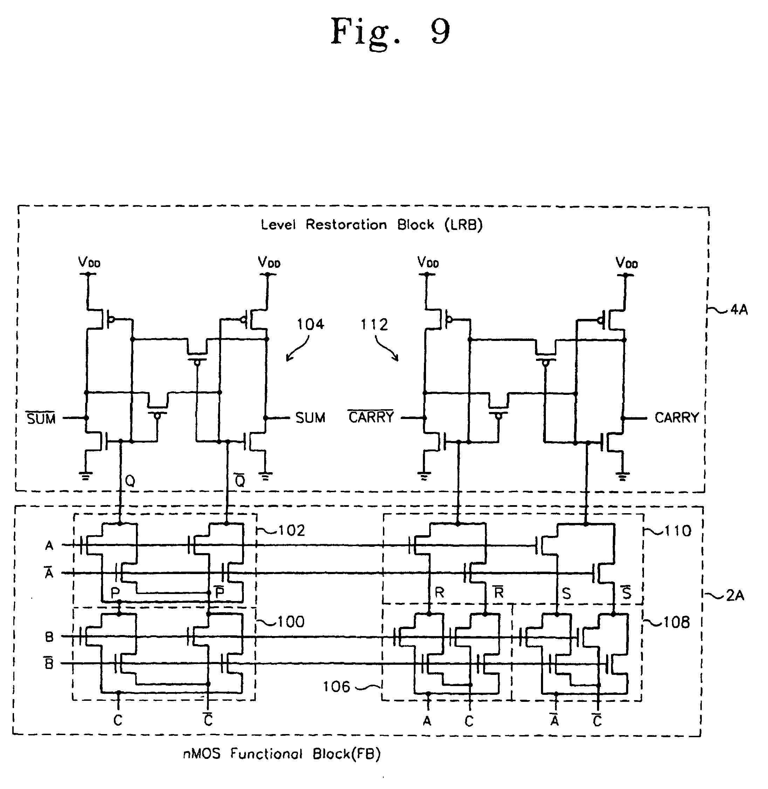

FIG. 9 shows a 1-bit full adder which has a level restoration block 4A and a functional block 2A according to the present invention. In FIG. 9, of input signals A, B and C of the 1-bit full adder, a reference symbol A indicates a most significant bit (MSB) and C does a least significant bit (LSB). Two low-order bits of the input signals B and C, and complementary signals $\overline{\text{B}}$ and $\overline{\text{C}}$ thereof are provided to a first addition section 100 of the functional block 2A to be added. Partial sum signal P and complementary signal $\overline{\text{P}}$ of the first addition section 100, as well as the MSB signal A and the complementary signal $\overline{\text{A}}$ thereof are provided to the second addition section 102 to be added. Sum signal Q and complementary signal $\overline{\text{Q}}$ from the second addition section 102 are provided to an EEPL level restoration circuit 104 in the level restoration block 4A, and are restored to full levels by the EEPL level restoration circuit 104 to be outputted as a final sum signal SUM and a complementary signal $\overline{\text{SUM}}$ thereof.

Also, the input signals and the complementary signals thereof are provided to third and fourth addition section 108. A fifth addition section 110 performs the addition of a partial sum signal R of the third addition section 106, a complementary signal $\overline{\text{R}}$ of the partial R, the other partial sum signal S of the third addition section 106, a complementary signal $\overline{\text{S}}$ of the partial sum signal S, the MSB signal A and the complementary signal $\overline{\text{A}}$ of the MSB signal to output a carry signal T and a complementary signal $\overline{\text{T}}$ thereof.

The signals T and $\overline{\text{T}}$ from the fifth addition section 110 are provided to the EEPL circuit 112 of the level restoration block 4A, and restored to full levels by the EEPL level restoration circuit 104 to be outputted as both a final carry signal CARRY and a complementary signal $\overline{\text{CARRY}}$ thereof.

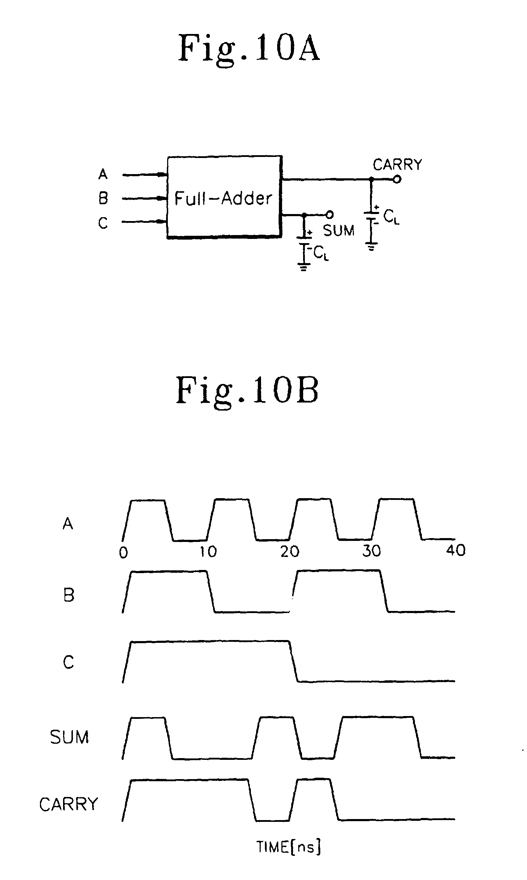

FIG. 10A shows ideal simulation environment of the 1-bit full adder shown in FIG. 9. In this 1-bit full adder, as power consumption (PxD) is increased, a load capacitance is also increased. Herein, P indicates a power and D does a delay. FIG. 10B is a waveform diagram of input and output signals of the full adder shown in FIG. 10A. In FIGs. 10A and 10B, reference symbols A, B and C all indicate the input signals of the full adder, respectively. A reference symbol SUM indicates the sum signal and a reference symbol CARRY does the carry signal.

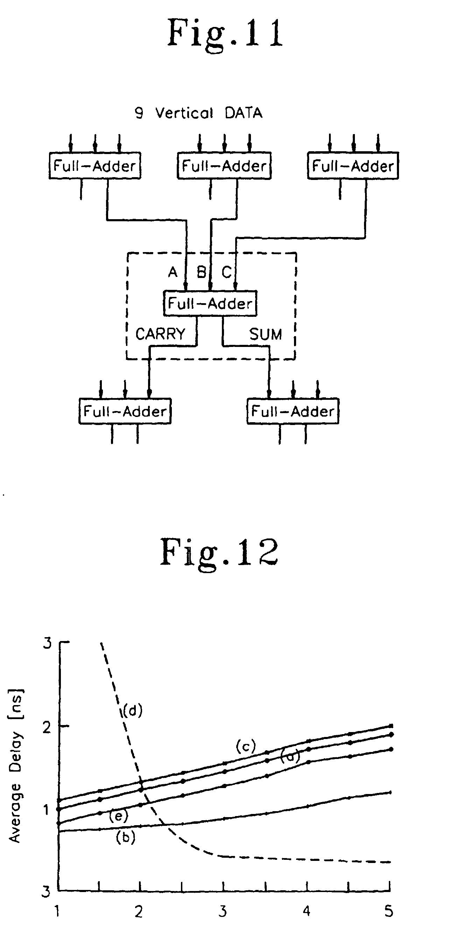

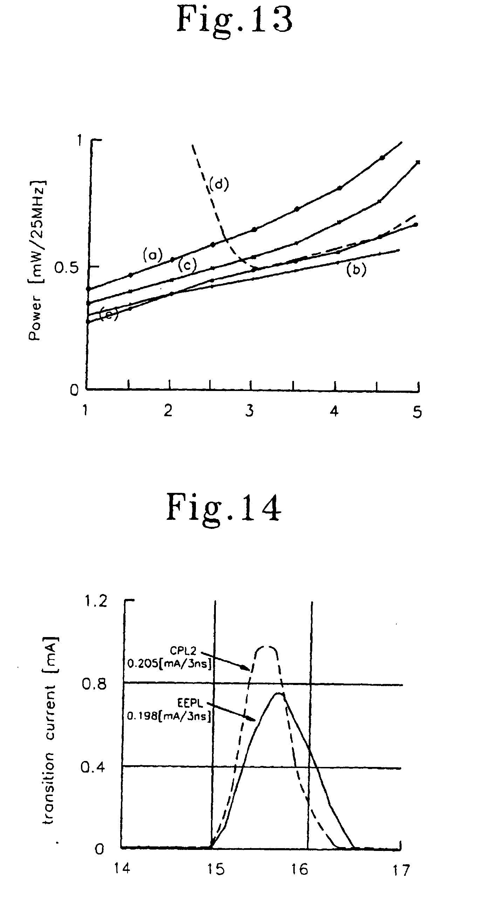

FIG. 11 shows the simulation environment of a cascade full adder chain, and FIGs. 12 and 13 show graph diagrams showing an average delay characteristic of the pass-transistor logic in the full adder chain shown in FIG. 11, and a power consumption characteristic of the pass-transistor logic in the full adder chain shown in FIG. 11, respectively.

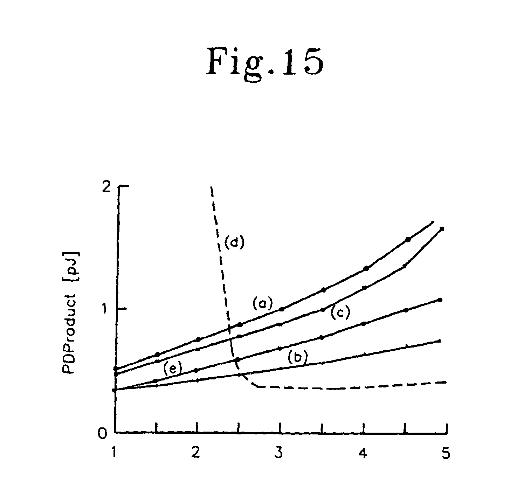

In FIG. 14, transition current processes of the pass-transistor logic of the prior art and the pass-transistor logic according to the present invention are illustrated as curves. FIG. 15 is a graph diagram showing power (P)xdelay(D) characteristic of the respective pass-transistor logic in the full adder chain shown in FIG. 11.

In FIG. 12, FIG. 13 and FIG. 15, an x-axis indicates the relative ratio (m) of W(width)/L(length) of the function block, reference symbols 'a' through 'e' indicate CPL, CPL2, Standalone, SRPL and EEPL of the present invention.

It can be seen from FIG. 12 that a delay is increased in proportion to the relative ratio of W/L, and that the delay of the EEPL according to the present invention is shortened as compared with that of the prior art CPL or the prior art SRPL. Also, it can be seen that the prior art SRPL is not nearly operated when the W/L ratio thereof is small, or when transistor size is small. The prior art SRPL is normally operated only when being fabricated in proportion to three or four times of the basic W/L ratio. Therefore, the SRPL structure is not preferable in the light of the reduction of chip area.

Also, it can be seen from FIG. 13 that, when the W/L ratio is low, the power dissipation of the EEPL according to the present invention is reduced less than that of the prior art CPL2. This is because peak current of the EEPL is less than that of the prior art CPL2, as shown in FIG. 14.

From FIG. 15, it can be seen that the power (P)xdelay(D) characteristic of the EEPL is somewhat larger than that of the prior art CPL2 in spite of a superior performance to the prior art CPL or the prior art SRPL. Also, the relative energy consumption of the EEPL is somewhat larger than that of the prior art CPL2, but has superior characteristics to the prior art CPL2 in the light of power.

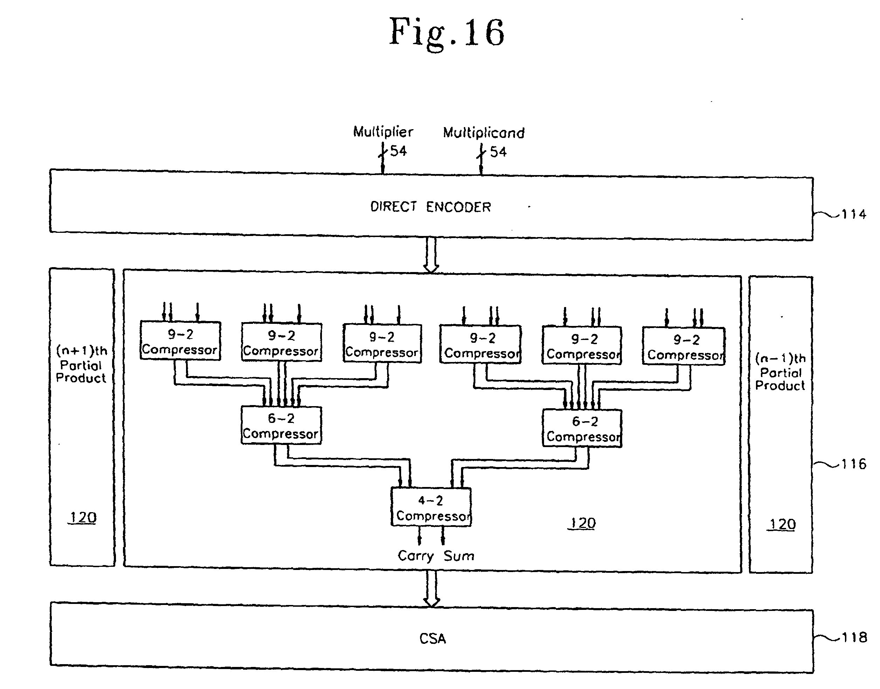

FIG. 16 shows a (54x54)-bit multiplier according to the present invention. Referring to FIG. 16, the (54x54)-bit multiplier an encoder 114 for producing fifty-four vertical data signals each of which has fifty-four bits, a Wallace's tree compressor 116 for compressing each 54-bit vertical data signal into a 2-bit signal, for example a carry signal and a sum signal, and a 108-bit conditional sum adder 118 for generating a multiplication result by adding the sum signals, with propagating the carry signals.

The encoder 114 which constituted with a plurality of multiplexers is provided to receive a 54-bit multiplier signal and a 54-bit multiplicand signal, and to produce the fifty-four 54-bit vertical data signals. In the encoder 114, if a bit value of the 54-bit multiplicand signal is '1', a bit value of the 54-bit multiplier is directly outputted. If the bit value of the 54-bit multiplicand signal is '0', a bit value is set to '0' to be outputted. An n-th vertical data signal becomes equal to a partial product of the 54-bit multiplier signal and an n-th bit value of the 54-bit multiplicand signal, where n is 1, 2,..., 54. Consequently, fifty-four partial products corresponding to the multiplicand signal of MSB to LSB are produced as the fifty-four vertical data signals. The following table 2 illustrates the production of the vertical data signals in case of a (4x4) multiplier.

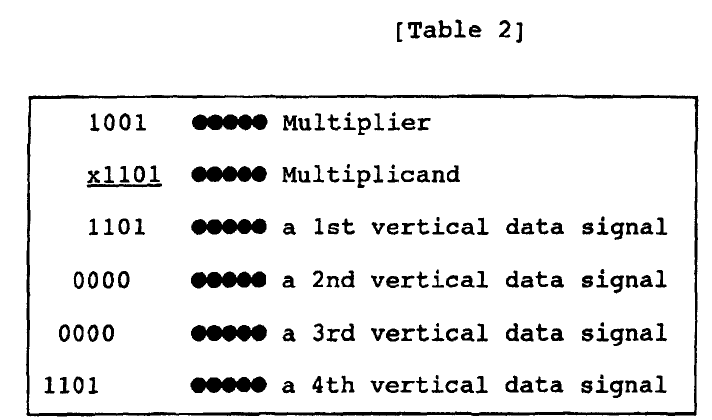

As depicted by the table 2, if the 4-bit multiplier data '1101' is multiplied by the 4-bit multiplicand data '1101', the first to fourth vertical data signals are produced as '1101', '0000', '0000' and '1101' in accordance with respective bit values of the multiplicand data. The first and fourth vertical data signals, which correspond to the MSB and LSB of the multiplicand data whose both bit values are '1', have the same data as the multiplier data '1101'. The second and third vertical data signals, which correspond to the other bits of the multiplicand data whose both bit values are '0', have '0000'. All the vertical data signals are provided to the Wallace's tree compressor 116.

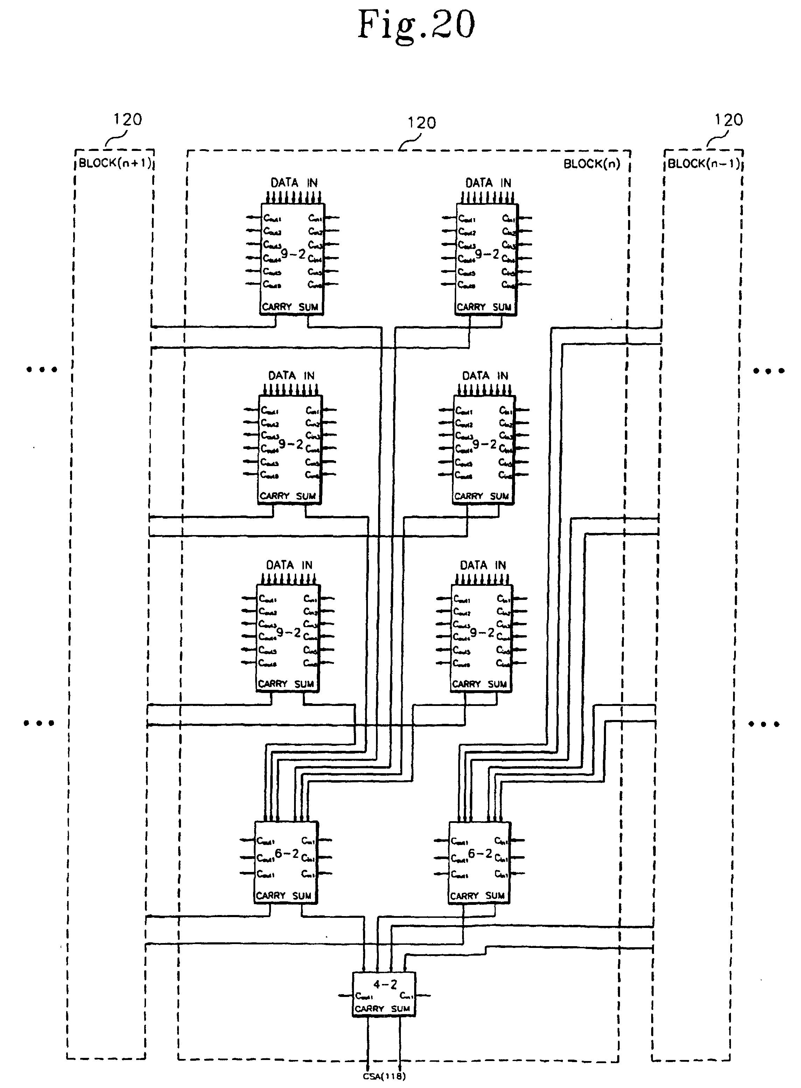

Turning again to FIG. 16, the Wallace's tree compressor 116 is constituted with fifty-four compression units 120 corresponding to the fifty-four vertical data signals. Each compression unit has six 9-to-2 compressors, two 6-to-2 compressors and a 4-to-2 compressor. The 54-bit vertical signal from the encoder 114 is divided in 9-bit signals to be provided to the six 9-to-2 compressors. Each 9-to-2 compressor compresses a corresponding 9-bit signal and produce a 2-bit signal, ie carry and sum signals. 12-bit data signal from the six 9-to-2 compressors is divided in 6-bit signals to be provided to the two 6-to-2 compressors. Also, 4-bit data signal from the 6-to-2 compressor is provided to the 4-to-2 compressor. With this construction of the Wallace's tree compressor 116, a single compressor produces a 2-bit data, ie a carry and a sum signal, and thus the compressor 116 can produce a 108-bit data signal. The 108-bit data signal from the Wallace's tree compressor 116 is provided to the 108-bit conditional sum adder 118. In FIG. 20, an example of the compression unit 120 is illustrated.

As described immediately above, the 108-bit carry and sum signals from the fifty-four compression units related to the fifty-four vertical data signal have the same delay time and are provided to the conditional sum adder 118. As a result, a (54x54)-bit multiplication data is finally produced by the conditional sum adder 118.

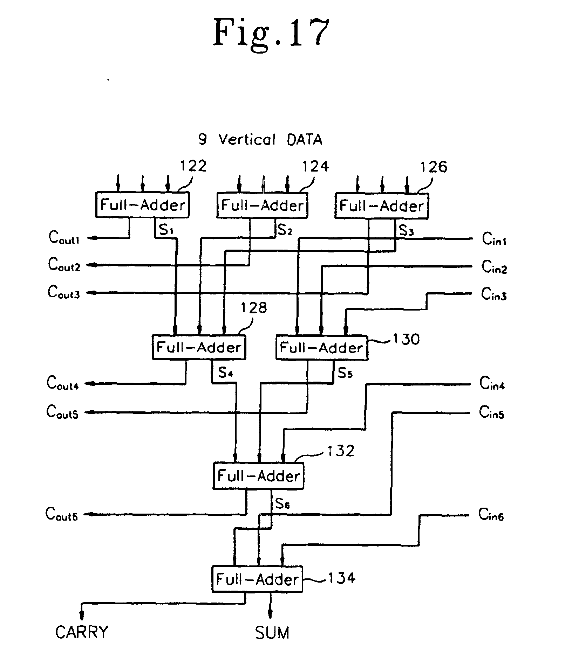

FIG. 17 shows one of the 9-to-2 compressors of FIG. 16. In this FIG., each of the 9-to-2 compressors has seven full adders 122^{~}134, each of which has the same construction as the full adder of FIG. 9. The 9-to-2 compressor receives a 9-bit data of the 54-bit vertical data provided from the encoder 114 and a six bit carry signal Cᵢₙ₁^{~}Cᵢₙ₆ provided from a k-th 9-to-2 compressor of an (n-1)-th compression unit, and produces a carry bit signal CARRY, a sum bit signal SUM and the other carry bit signals Cₒᵤₜ₁^{~}Cₒᵤₜ₆ to be provided to a corresponding compressor, ie the k-th 9-to-2 compressor of a (n+1)-th compression unit.

As shown in FIG. 17, the 9-bit vertical data signal from the encoder 144 is divided in 3-bit signals, which are respectively provided to a first to a third full adders 122, 124 and 126. These full adders then produce a first to a third sum bit signals S₁^{~}S₃ and a first to a third carry bit signals Cₒᵤₜ₁^{~}Cₒᵤₜ₃ to be provided to the k-th 9-to-2 compressor of a next stage compression unit, ie the (n+1)-th compression unit. The fourth full adder 128 receives the first to the third sum bit signals S₁^{~}S₃ and produces a fourth sum bit signal S₄ and a fourth carry bit signal Cₒᵤₜ₄ to be provided to the k-th 9-to-2 compressor of the next stage compression unit. The fifth full adder 130 receives the first to the third carry bit signals Cᵢₙ₁^{~}Cᵢₙ₃ from a pre-stage compression unit, ie the (n-1)-th compression unit and produces a fifth sum bit signal S₅ and a fifth carry bit signal Cₒᵤₜ₅ to be provided to the k-th 9-to-2 compressor of the next stage compression unit. The sixth full adder 132 receives the fourth and fifth sum bit signals S4 and S5 and the fifth carry bit signal Cᵢₙ₄ from a corresponding 9-to-2 compressor of the pre-stage compression unit and produces a sixth sum bit signal S₆ and a sixth carry bit signal Cₒᵤₜ₆ to be provided to a corresponding 9-to-2 compressor of the next stage compression unit. The seventh full adder 134 receives the sixth sum bit signal S₆ from the sixth full adder and the fifth and sixth carry bit signals Cᵢₙ₅ and Cᵢₙ₆ from the pre-stage compression unit and finally produces the sum bit signal SUM and the carry bit signal CARRY.

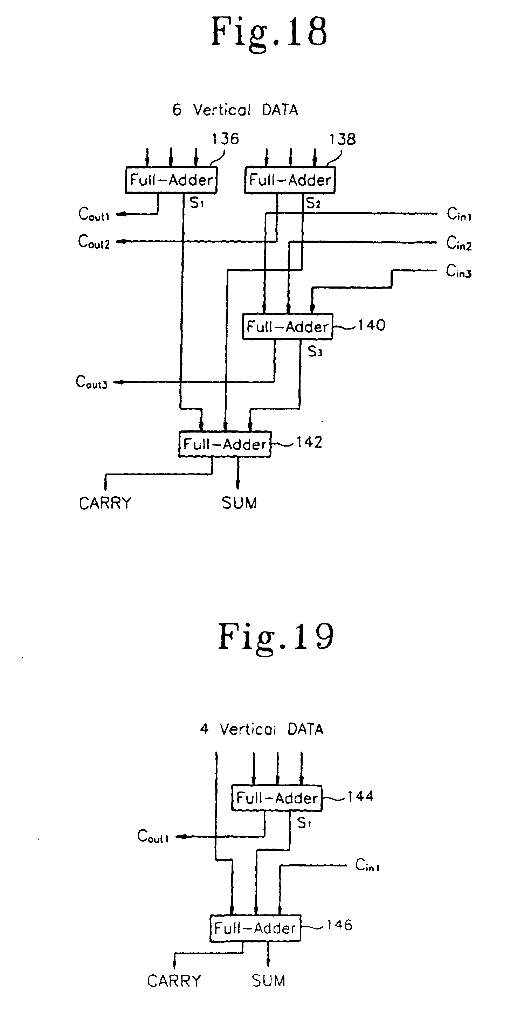

FIG. 18 shows one of the two 6-to-2 compressors of FIG. 16. Each of the two 6-to-2 compressors has four full adders 136, 138, 140 and 142, each of which has the same construction as the full adder of FIG. 9. In this FIG., each of the two 6-to-2 compressors receives a 6-bit data of the 12-bit vertical data signal from the six 9-to-2 compressors and a 3-bit carry signal Cᵢₙ₁^{~}Cᵢₙ₃ from a first 6-to-2 compressor of the pre-stage compressor unit, ie the (n-1)-th compression unit, and generates the carry bit signal CARRY, the sum bit signal SUM and the other carry bit signals Cₒᵤₜ₁^{~}Cₒᵤₜ₃ to be provided to a corresponding 6-to-2 compressor of the next-stage compression unit, ie the (n+1)-th compression unit.

Referring again to FIG. 18, the 6-bit vertical data signal from three corresponding 9-to-2 compressors is divided in 3-bit signals to be provided to the first and second full adders 136 and 138. These full adders 136 and 138 then produce first and second sum bit signals S₁ and S₂ as well as first and second carry bit signals Cₒᵤₜ₁ and Cₒᵤₜ₂ to be provided to a first 6-to-2 compressor of the next stage compression unit, ie the (n+1)-th compression unit. The third full adder 140 receives the first to the third carry bit signals Cᵢₙ₁^{~}Cᵢₙ₃ from a corresponding 6-to-2 compressor of the pre-stage compression unit, and produces a third sum bit signal S₃ and a third carry bit signal Cₒᵤₜ₃ to be provided to the first 6-to-2 compressor of the next stage compression unit. The fourth full adder 142 receives the first to the third sum bit signals S₁^{~}S₃ from the first to third full adders and finally produces the sum bit signal SUM and the carry bit signal CARRY.

FIG. 19 shows the 4-to-2 compressor of FIG. 16. The 4-to-2 compressor has two full adders 144 and 146, each of which has the same construction as the full adder of FIG. 9. In this FIG., the 4-to-2 compressor receives a 4-bit vertical data signal from the two 6-to-2 compressors and a 1-bit carry signal Cᵢₙ₁ from a corresponding 4-to-2 compressor of the pre-stage compressor unit, ie the (n-1)-th compression unit, and generates the carry bit signal CARRY, the sum bit signal SUM and the other carry bit signal Cₒᵤₜ₁ to be provided to a corresponding 4-to-2 compressor of the next-stage compression unit.

Referring again to FIG. 19, a low-order 3-bit signal of the 4-bit vertical data signal from two corresponding 6-to-2 compressors is provided to the first full adder 144 which produces a first sum bit signal S₁ as well as a carry bit signal Cₒᵤₜ₁ to be provided to the 4-to-2 compressor of the next stage compression unit. The second full adder 140 receives the MSB of the 4-bit vertical data signal, the sum bit signal S₁ from the first full adder 144 and the carry bit signal Cᵢₙ₁ from the 4-to-2 compressor of the pre-stage compression unit, and produces final sum and carry bit signals SUM and CARRY. The sum and carry bit signals produced thus are supplied to the 108-bit conditional sum adder 116, as shown in FIG. 16.

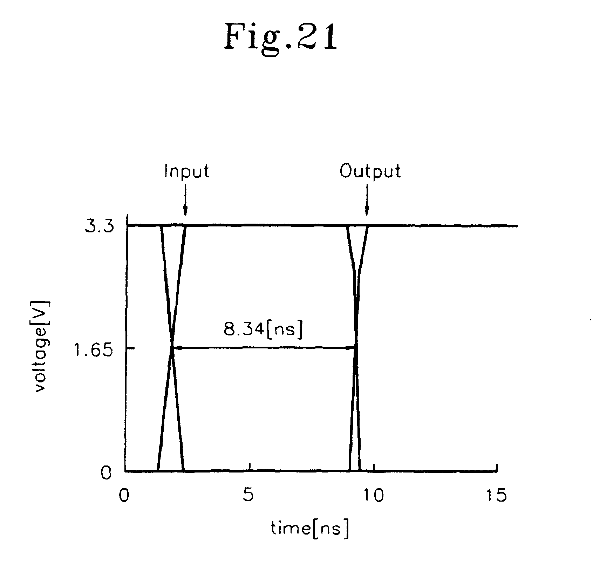

FIG. 21 shows simulation results of a threshold path in the compression unit according to the present invention. From this FIG., it can be seen that the time of about 8.34 nanoseconds is required to obtain an output from an input.

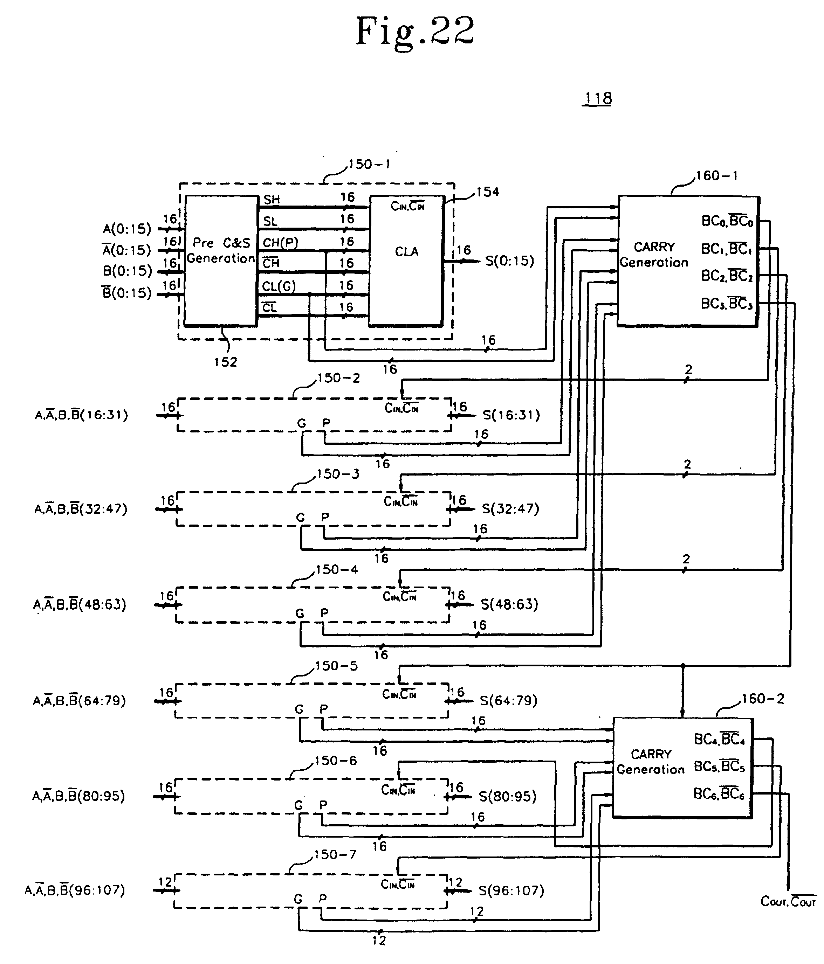

FIG. 22 shows the 108-bit conditional sum adder circuit of FIG. 16 according to a preferred embodiment of the present invention. The 108-bit conditional sum adder 118, as shown in FIG. 22, is constituted with seven moduled 16-bit sum generation blocks 150-1^{~}150-7, and two 4-bit carry generation blocks 160-1 and 160-2. The number of the carry generation blocks is equal to the ceiling value of the number of the sum generation blocks, ie ┌7/4┐=2. Each of the sum generation blocks 150-1~150-7 has a pre-carry&pre-sum generator 152 and a 16-bit conditional sum adder 154. The sum generation blocks are constituted with EEPL and the carry generation blocks with CMOS logic.

In this embodiment, it is the most significant feature of the 108-bit conditional sum adder that, before carry propagation which is generated through multiplexer chain in respective sum generation blocks 150-1^{~}150-7 arrives at the final stage of the multiplexer chain, the final stage is driven by block carry signals BCᵢ and $\overline{{\text{BC}}_{\text{i}}}$ provided from the respective carry generation blocks 160-1 and 160-2. For example, the carry generation and the sum generation occur simultaneously in the prior art conditional sum adder, but individually in the conditional sum adder 118 according to the present invention. Therefore, the conditional sum adder 118 of FIG. 22 can achieve an improved operation speed. Namely, the conditional sum adder 118 has a shorten delay time of about 2t_{MUX} in comparison with the prior art conditional sum adder.

Also, since the sum generation blocks are constituted with pass-transistor logic and the carry generation blocks with CMOS logic, the 108-bit conditional sum adder 118 has a faster operation speed and a lower power dissipation, as compared with the prior art conditional sum adder having either the pass-transistor logic or the CMOS logic.

Turning to FIG. 22, the respective pre-carry&pre-sum generators 152 in the first to sixth sum generation blocks, 150-1^{~}150-6 receive a first 16-bit input signal Aᵢ~Aᵢ₊₁₅ (where "I" is equal to 0, 16, 32 ..., 80), a complementary signal ($\overline{{\text{A}}_{\text{i}}}$^{~}$\overline{{\text{A}}_{\text{i+15}}}$ of the first 16-bit input signal, a second 16-bit input signal Bᵢ~Bᵢ₊₁₅ and a complementary signal $\overline{{\text{B}}_{\text{i}}}$^{~}$\overline{{\text{B}}_{\text{i} \text{+15}}}$ of the second 16-bit input signal, and generate a first 16-bit conditional sum signal SH, a second 16-bit conditional sum signal SL, a first 16-bit conditional carry signal CH or P, a complementary signal $\overline{\text{CH}}$ of the first 16-bit conditional sum signal SH, a second 16-bit conditional carry signal CL or G, and a complementary signal $\overline{\text{CL}}$ of the second 16-bit conditional carry signal. Also, the pre-carry&pre-sum generator 152 in the seventh sum generation block receives a first 12-bit input signal A₉₆~A₁₀₇, a complementary signal $\overline{{\text{A}}_{\text{96}}}$^{~}$\overline{{\text{A}}_{\text{107}}}$ of the first 12-bit input signal, a second 12-bit input signal B₉₆~B₁₀₇ and a complementary signal $\overline{{\text{B}}_{\text{96}}}$~$\overline{{\text{B}}_{\text{107}}}$ of the second 16-bit input signal, and generates a first 12-bit conditional sum signal SH, a second 12-bit conditional sum signal SL, a first 12- bit conditional carry signal CH or P, a complementary signal $\overline{\text{CH}}$ of the first 12-bit conditional carry signal CH, a second 12-bit conditional carry signal CL or G, and a complementary signal $\overline{\text{CL}}$ of the second 12-bit conditional carry signal.

In each of the first to seventh sum generation blocks 150-^{1~}150-7, the conditional sum adder 154 receives several signals from the pre-carry&pre-sum generator 152, ie the first conditional sum signal SH, the second conditional sum signal SL, the first conditional carry signal P, the complementary signal $\overline{\text{CH}}$ of the first conditional sum signal SH, the second conditional carry signal G, and the complementary signal $\overline{\text{CL}}$ of the second conditional carry signal.

The first to sixth 16-bit conditional sum adders of the seven sum generation blocks 150-1^{~}150-7 generates a first to sixth 16-bit sum signals Sᵢ~Sᵢ₊₁₅ (where "I" is 0, 16, 32,..., 80) and the seventh 16-bit conditional sum adder thereof generates a seventh 16-bit sum signal S₉₆~S₁₀₇.

Also, in the first to fourth sum generation blocks 150-1^{~}150-4, the first and second conditional carry signals P and G from the pre-carry&pre-sum generators 154 are applied to the first carry generation block 160-1. In the fifth to seventh sum generation blocks 150-5^{~}150-7, the first and second conditional carry signals P and G from the pre-carry&pre-sum generators 154 are applied to the second carry generation block 160-2. The first and second conditional carry signals P and G indicate carry propagation and carry generation signals, respectively.

The first carry generation block 160-1 generates first to fourth block carry signals BC₀~BC₃ and complementary signals $\overline{{\text{BC}}_{\text{0}}}$^{~}$\overline{{\text{BC}}_{\text{3}}}$ thereof , al l of which are provided to the second sum generation block 150-2. Second block carry signal BC₁ and the complementary signal $\overline{{\text{BC}}_{\text{1}}}$ thereof are provided to the third sum generation block 150-3. Third block carry signal BC₂ and the complementary signal $\overline{{\text{BC}}_{\text{2}}}$ thereof are provided to the fourth sum generation block 150-4. Fourth block carry signal BC₃ and the complementary signal $\overline{{\text{BC}}_{\text{3}}}$ thereof are provided to the fifth sum generation block 150-5 and the second carry generation block 160-2. Each of the block carry signals is a 1-bit signal.

The second generation block 160-2 generates the fifth to seventh block carry signals BC₄^{~}BC₆ and the complementary signals $\overline{{\text{BC}}_{\text{4}}}$^{~}$\overline{{\text{BC}}_{\text{6}}}$ thereof. The fifth block carry signal BC₄ and the complementary signal $\overline{\text{BC} {}_{\text{4}}}$ thereof are supplied to the sixth sum generation block 150-6. The sixth block carry signal BC₅ and the complementary signal $\overline{{\text{BC}}_{\text{5}}}$ supplied to the seventh sum generation block 150-7. And, the seventh block carry signal BC₆ and the complementary signal $\overline{{\text{BC}}_{\text{6}}}$ are generated as the final carry and complementary signals Cₒᵤₜ and $\overline{{\text{C}}_{\text{OUT}}}$, respectively.

As described above, the 108-bit conditional sum adder according to the present invention deals with the carry generation and the sum generation separatively, so that the operation speed thereof can be improved faster. That is, the delay time of the sum generation block is 10t_{MUX} which is comprised of, for example, tₓᵤₓ due to the pre-carry&pre-sum generator 152, 8t_{MUX} due to the 16-bit conditional sum adder 154 and t_{MUX} due to the block carry signals BCⱼ and $\overline{{\text{BC}}_{\text{J}}}$ (or C_{IN} and $\overline{{\text{C}}_{\text{IN}}}$ from the carry generation block 160-1 or 160-2. However long the delay time due to the carry generation blocks 160-1 and 160-2 is, it is not exceeded by 8t_{MUX}. The delay time due to the carry generation block is shortened in comparison with that of the sum generation block. Accordingly, the carry propagation time is faster than the sum propagation time so that addition speed is performed relatively fast.

In addition, the 108-bit conditional sum adder has seven sum generation blocks 150-1^{~}150-7, ie seven 16-conditional sum adders. This (7x16) adder structure has a lower delay time, as compared with a prior art (8x14), (12x9) or (29x6) adder structure. As an example, in case of the (8x14) adder structure, the delay time of the sum generation block is 5t_{MUX} which is comprised of t_{MUX} due to the pre-carry&pre-sum generator and 4t_{MUX} due to the sum generator (where t_{MUX} is a delay time due to one multiplexer). The delay time due to the carry generation block is about 12t_{MUX} even though the block is implemented with group carry and group sum methods. Thus, the 108-bit conditional sum adder having a prior art (8x14) adder structure has at least 12t_{MUX} of delay time. The delay times of respective adder structures are illustrated by the following Table 3.

**[Table 3]**

| Adder Structure | Delay Time of Sum Generation Block (t_{MUX}) | Delay Time of Carry Generation Block (t_{MUX}) | Total Delay Time (t_{MUX}) |
|---|---|---|---|
| 8x14 | 5 | 11 | 12 |
| 12x9 | 7 | 10 | 11 |
| 7x16 | 9 | 9 | 10 |
| 20x6 | 11 | 10 | 12 |

As can be seen from Table 3, the (7x16) adder structure according to the present invention has the most short delay time in total, as compared with the other prior art adder structures.

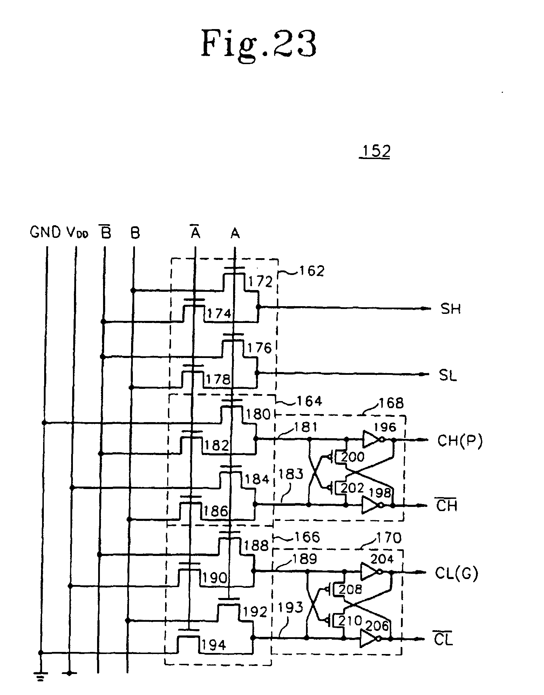

FIG. 23 is a detailed circuit diagram of a pre-carry&pre-sum generator according to this embodiment. Referring to FIG. 23, the generator 152 includes sixteen pre-carry & pre-sum generation units. Each of the generation units three function blocks 162, 164 and 166, and two EEPL level restoration blocks 168 and 170.

First function block 162 includes two NMOS transistors 172 and 174 for XNORing inputs A and B, and two NMOS transistors 176 and 178 for XORing inputs A and B. The XNOR logic outputs SH, and the XOR logic outputs SL. Second function block 164 is composed of two NMOS transistors 180 and 182 for NORing inputs A and B, and two NMOS transistors 184 and 186 for ORing inputs A and B.

The NOR logic outputs $\overline{\text{CH}}$ (or $\overline{\text{P}}$), the OR logic outputs CH (or P). Third function block 166 is composed of two NMOS transistors 190 and 192 for NANDing inputs A and B, and two NMOS transistors 192 and 194 for ANDing inputs A and B. The NAND logic outputs $\overline{\text{CL}}$ (or $\overline{\text{G}}$), the AND logic outputs CL (or G).

Two output terminals of the second function block 164 are connected with first EEPL level restoration block 168, those of the third function block 166 is connected with second EEPL level restoration block 170. Each level restoration block, as described before with reference to FIG. 8, includes two invertors and two PMOS transistors. Specifically, in first level restoration block 168, input terminal of invertor 196 is connected to output terminal 181 of NOR logic, and CH (or P) is outputted from output terminal of the invertor 196. Input terminal of invertor 198 is connected to output terminal 183 of NOR logic, and $\overline{\text{CH}}$ (or P) is outputted from output terminal of the invertor 198. Current path of PMOS transistor 200 is connected between the input terminal of the invertor 196 and the output terminal of the invertor 198, and gate terminal thereof is connected with the input terminal of the invertor 198. Current path of PMOS transistor 202 is connected between the input terminal of the invertor 198 and the output terminal of the invertor 196, and gate terminal thereof is connected with the input terminal of the invertor 196.

In second level restoration block 170, input terminal of invertor 204 is connected to output terminal 189 of NAND logic, and CL (or G) is outputted from output terminal of the invertor 204. Input terminal of invertor 206 is connected to output terminal 193 of AND logic, and $\overline{\text{CL}}$ (or $\overline{\text{G}}$) is outputted from output terminal of the invertor 206.

Current path of PMOS transistor 208 is connected between the input terminal of the invertor 204 and the output terminal of the invertor 206, and gate terminal thereof is connected with the input terminal of the invertor 206. Current path of PMOS transistor 210 is connected between the input terminal of the invertor 206 and the output terminal of the invertor 204, and gate terminal thereof is connected with the input terminal of the invertor 204.

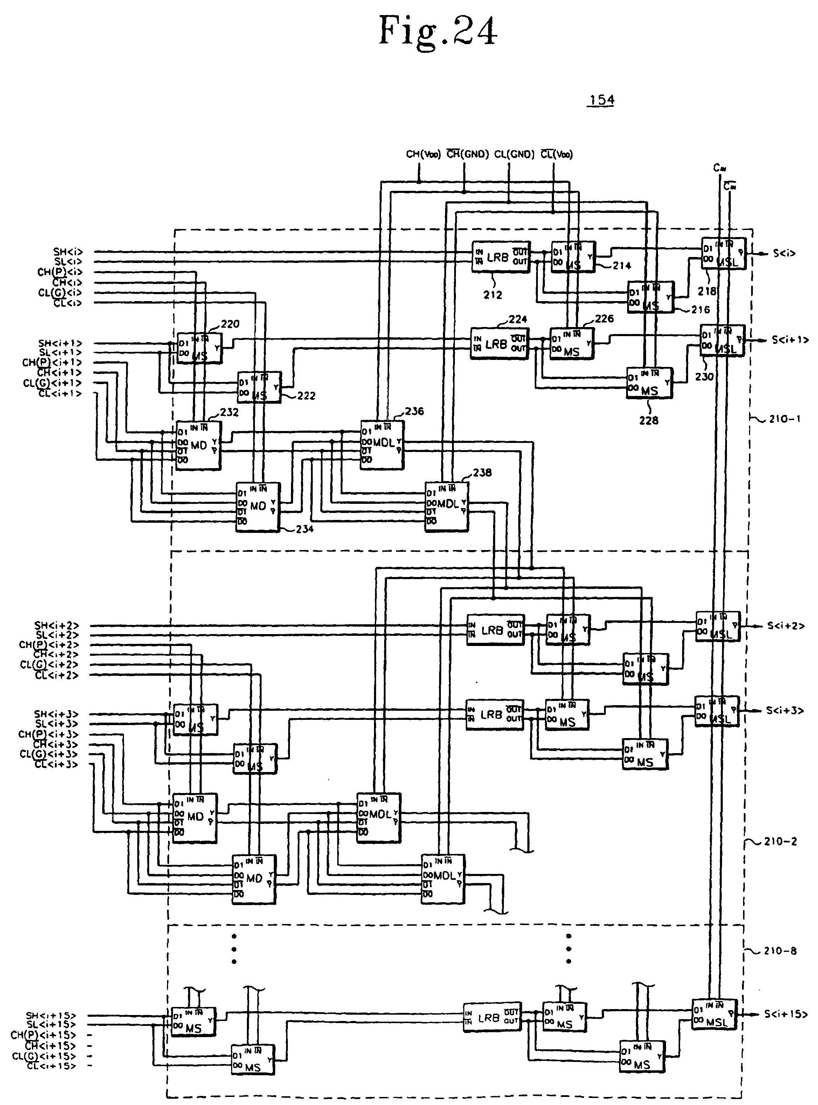

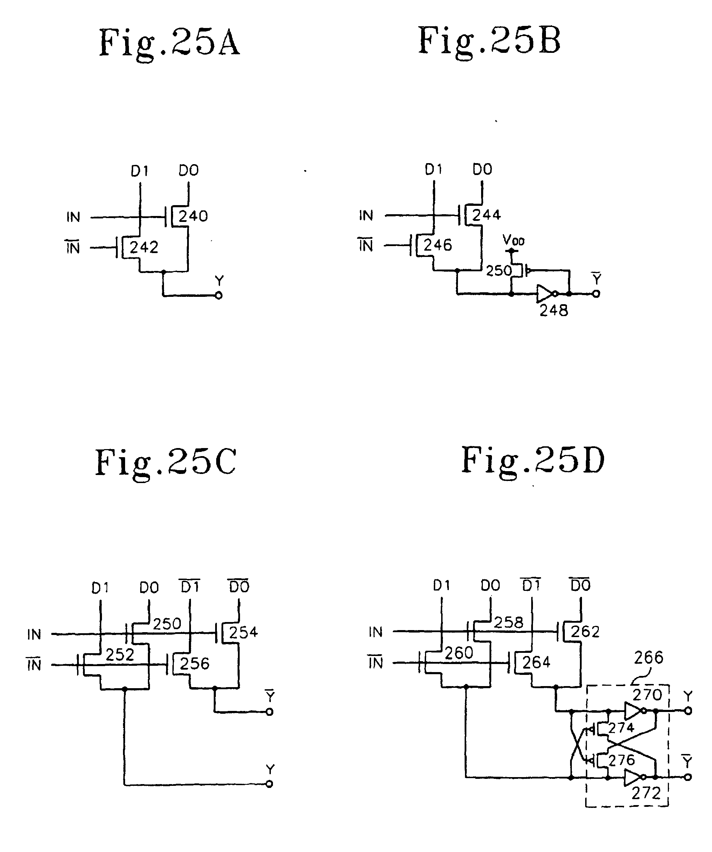

FIG. 24 is a detailed circuit diagram of 16-bit conditional sum adder. Referring to FIG. 24, the adder 154 includes a plurality of multiplexers. In FIG. 24, LRB represents the EEPL level restoration circuit of FIG. 8, MS. MSL, MD and MDL represent pass-transistor multiplexers of FIGs. 25A to 25D, respectively. MS denotes a single multiplexer selectively outputting one of two data D0 and D1 in accordance with two complementary inputs IN and $\overline{\text{IN}}$. As shown in FIG. 25A, the MS has two NMOS transistors 240 and 242. MSL is a single multiplexer with level restoration circuit, and it outputs the converted signal of one of two data. This MSL, as shown in FIG. 25B, includes two NMOS transistors 244 and 246, an invertor 248, and a PMOS transistor 250. Further, MD is a dual multiplexer which selectively outputs one of two data and one of its complementary data in accordance with two complementary inputs. The MD includes four NMOS transistors 250, 252, 254 and 256, as shown in FIG. 25C. MDL is a dual multiplexer with level restoration circuit, and it outputs inverted signals of outputs of the dual multiplexers. The MDL, as shown in FIG. 25D, includes four NMOS transistors 258, 260, 262 and 264, and EEPL level restoration circuit 266. The EEPL level restoration circuit 266, as described before, includes two invertors 270 and 272, and two PMOS transistors 274 and 276.

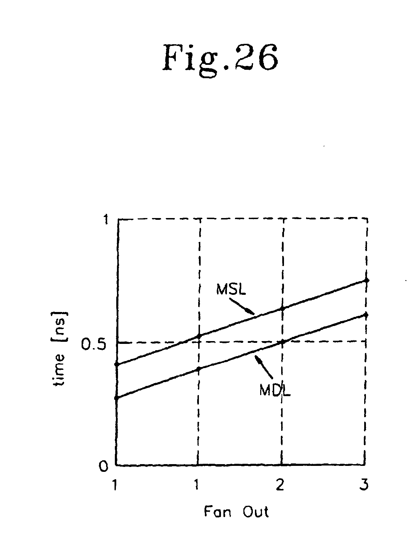

The SPICE simulation result of MSL and MDL is shown in FIG. 26. Referring to FIG. 26, the delay of MDL is shorter than that of MSL. Referring back to FIG. 24, 16-bit conditional sum adder 154 includes eight conditional sum units 210-1 ^{~} 210-8. First conditional sum unit 210-1 receives first conditional sum signals SH and second conditional sum signals SL, first conditional carry signals CH (or P) and second conditional carry signals CL (or G), and 2-bit lower order signals SHᵢ and SHᵢ₊₁, SLᵢ and SLᵢ₊₁, CHᵢ and CHᵢ₊₁, $\overline{{\text{CH}}_{\text{i}}}$ and $\overline{{\text{CH}}_{\text{i} \text{+1}}}$, CLᵢ and CLᵢ₊₁, $\overline{{\text{CL}}_{\text{i}}}$ and $\overline{{\text{CL}}_{\text{i} \text{+1}}}$ of respective complementary signals $\overline{\text{CL}}$ of the second conditional carry signals which are provided from corresponding pre-carry & pre-sum generator 152, and generates 2-bit sum signals Sᵢ and Sᵢ₊₁. Second conditional sum unit 210-2 receives next 2-bit signals SHᵢ₊₂ and SHᵢ₊₃, SLᵢ₊₂ and SLᵢ₊₃, CHᵢ₊₂ and CHᵢ₊₃, $\overline{{\text{CH}}_{\text{i} \text{+2}}}$ and $\overline{{\text{CH}}_{\text{i} \text{+3}}}$, CLᵢ₊₂ and CLᵢ₊₃, $\overline{{\text{CL}}_{\text{i} \text{+2}}}$ and $\overline{{\text{CH}}_{\text{i} \text{+3}}}$ from the corresponding pre-carry & pre-sum generator 152, and generates next 2-bit sum signals Sᵢ₊₂ and Sᵢ₊₃. Like this, first through eight conditional sum adder units 210-1 ^{~} 210-8 produces 16-bit sum signals Sᵢ ^{~} S₁₊₁₅·

Each conditional sum adder unit includes two LRBs 212 and 224, six Mss 214, 216, 220, 222, 226 and 228, two MSLs 218 and 230, two MDS 232 and 234 and two MDLs 236 and 238. In each conditional sum unit, input terminals IN and $\overline{\text{IN}}$ of first LRB 212 is supplied with lower order bit SH signal and lower order bit SL signal, respectively. The levels of the signals SH and SL are respectively restored to the full levels i.e., _{V.D.} and Vss (GND) by means of first LRB 212.

The full level signals SH and SL from output terminals OUT and $\overline{\text{OUT}}$ of the LRB 212 are provided to input terminals D0 and D1 of MS 214, respectively. Each of Mss 214 and 216 selectively outputs one of two inputs in response to selection signals. In the conditional sum adder unit 210-1, for example, select terminals IN and $\overline{\text{IN}}$ of the MS 214 are supplied with control signals of _{V.D.} and GND levels, respectively, and select terminals IN and $\overline{\text{IN}}$ of the MS 216 are supplied with control signals of GND and _{V.D.} levels, respectively. Therefore, the MS 214 outputs signal SH, and the MS 216 outputs signal SL.

The signals SH and SL from Mss 214 and 216 are applied to input terminals D1 and D0 of MSL 218, respectively. The MSL 218 outputs the converted signal of the signal SL from the MS 216, i.e., full high level signal as a least significant bit sum signal Si when a control signal C_{IN} is at _{V.D.} level. On the other hand, the MSL outputs the converted signal of the signal SH from the MS 214, i.e, full low level signal as the least significant bit sum signal Si when a control signal $\overline{{\text{C}}_{\text{IN}}}$ is at _{V.D.} level.

The input terminals D1 and D0 of the MS 220 are supplied with upper order bit SH signal and upper order bit SL signal, respectively. The input terminals D1 and D0 of the MS 222 are also supplied with the upper order bit SH signal and the upper order SL signal, respectively. The select terminals IN and $\overline{\text{IN}}$ of the MS 220 are provided with lower order bit signals CH(i.e., P) and $\overline{\text{CH}}$ (i.e., $\overline{\text{P}}$), respectively, and the select terminals IN and $\overline{\text{IN}}$ of the MS 222 are respectively provided with lower order bit signals CL (i.e., G) and $\overline{\text{CL}}$ (i.e., $\overline{\text{G}}$). Since the signals CH and $\overline{\text{CL}}$ are high and the signals CL and $\overline{\text{CH}}$ are low, the MSs 220 and 222 output signals SL and SH, respectively. The signals SL and SH are applied to the input terminals IN and $\overline{\text{IN}}$ of the LRB 224, respectively. Signals SH and SL of full levels are thus outputted from output terminals OUT and $\overline{\text{OUT}}$ of the LRB 224, respectively.

Input terminals D0 and D1 of the MS 226 are supplied with the signals SH and SL from the LRB 224, respectively. The signals SH and SL are also provided to the input terminals D0 and D1 of the MS 228, respectively. Each of the Mss 226 and 228 outputs one of two inputs selectively, in response to select signals. For instance, in the conditional sum adder unit 210-1, the select terminals IN and $\overline{\text{IN}}$ of the MS 226 are supplied with control signals of _{V.D.} and GND levels, respectively, and the select terminals IN and $\overline{\text{IN}}$ of the MS 228 are supplied with control signals of GND and _{V.D.} levels, respectively. Thus, the MS 226 outputs signal SH, and the MS 228 outputs signal SL.

The signal SH from the fifth MS 226 and the signal SL from the sixth MS 228 are provided with input terminals D1 and D0 of the second MSL 230. The second MSL 230 outputs the inverted SL signal, ie a strong high level signal, as a Summation signal S_{I+1} when the level of the control signal C_{IN} provided to its selection terminal IN is same as V_{DO} level. On the other hand, the second MSL 230 outputs the inverted SH signal, ie, a stron low level signal, as a Summation signal Sᵢ₊₁ when the level of the control signal $\overline{{\text{C}}_{\text{IN}}}$ provided to its selection terminal $\overline{\text{IN}}$ is same as _{V.D.} level.

The upper order bit CH signal and its inverted signal $\overline{\text{CH}}$, and the lower order bit CL signal and its inverted signal $\overline{\text{CL}}$ are supplied with the input terminals D0, $\overline{\text{DO}}$*,* D1, $\overline{\text{D1}}$ of the first and second MDs 232 and 234. The lower order bit CH(P) signal and the lower order bit $\overline{\text{CH}}$ ($\overline{\text{P}}$) signal are supplied with the input terminals IN and $\overline{\text{IN}}$ of the first MD 232. And the lower order bit CL (G) signal and the lower order bit $\overline{\text{CL}}$ ($\overline{\text{G}}$) are supplied with input terminals IN*,* $\overline{\text{IN}}$ of the second Mds 234. Since each CH and $\overline{\text{CL}}$ signals has high levels and each CL and $\overline{\text{CL}}$ signals is low levels, the first MD 232 outputs CL and $\overline{\text{CL}}$ signals and the second MD 234 outputs CH and $\overline{\text{CH}}$ signal.

CL, $\overline{\text{CL}}$, CH, and $\overline{\text{CH}}$ signals from the first and second MDs 232, 234 are supplied into input terminals D1, $\overline{\text{D1}}$, D0, $\overline{\text{D0}}$ of the first and second MDLs 236 and 238, respectively. Each of the first and second MDLs 236 and 238 outputs the one of its input signals and inverted input signals selectively in response to its selection signals. For examples, in the first conditional summation unit 210-1, a selection signal of _{V.D.} level and a selection signal of GND level are input into the select terminals IN and $\overline{\text{IN}}$ of the second MDL 238, respectively. Accordingly, the first MDL 236 selects and outputs signals CH and $\overline{\text{CH}}$ each of which is inverted from the signal CL and $\overline{\text{CL}}$, respectively, and the second MDL 238 selects and outputs signals CL and $\overline{\text{CL}}$ each of which is inverted fro the signal CH and $\overline{\text{CH}}$*,* respectively. The signals CH, $\overline{\text{CH}}$, CL, $\overline{\text{CL}}$ from the first and second MDLs 236 and 238 are provided as a control signal with the multiplexers within the next conditional summation unit. As shown in FIG. 24, according to the preferred embodiment of the invention, the delay time of 16 bits adder 154 is 8tₘᵤₓ. Compared with that of conventional one, this represents 56% improvements.

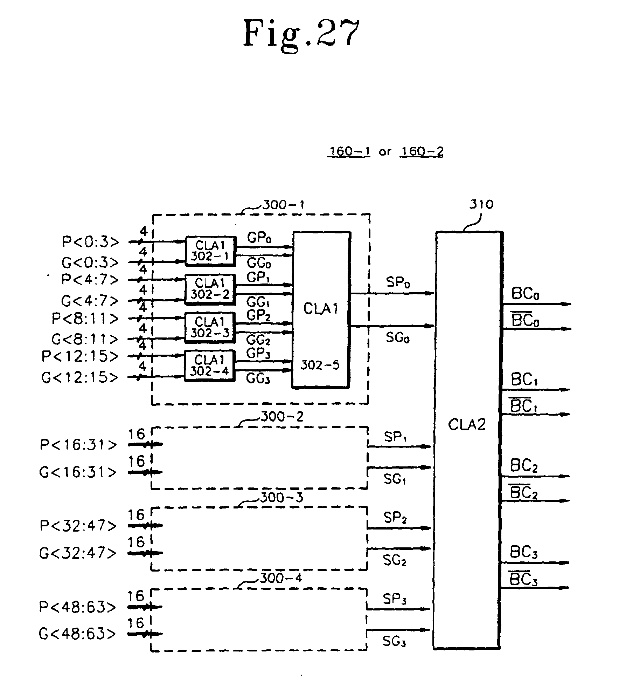

FIG. 27 shows carry generation block 160-1 schematically. Referring to the FIG. 27, carry generation block 160-1 comprises five CLA sections 300-1 ^{~} 300-4 and 310. The first to fourth CLA sections 300-1 ^{~} 300-4 have same structure with each other but the fifth CLA section 310 has different structure. Each of the first to fourth CLA sections 300-1 ^{~} 300-4 has five CLA1 adders 302-1 ^{~} 302-5 and the fifth CLA section has a CLA2 adder which has different structures.

In each the first to fourth CLA sections, 16 bits G signals and 16 bits P signals from corresponding pre-charge and pre-sum generator 152 are separated by 4 bits and supplied respectively with CLA1 adders 302-1 ^{~} 302-4.

Concretely, in the first CLA section 300-1, signals P0 ^{~} P3 and G0 ^{~} G3 are supplied with CLA1 adder 302-1 and signals P4 ^{~} P7 and G4 ^{~} G7 are supplied with CLA1 adder 302-2 and signals P8 ^{~} P11 and G8 ^{~} G11 are supplied with CLA1 adder 302-3 and signals P12 ^{~} P15 and G12 ^{~} G15 are supplied with CLA1 adder 302-4. CLA1 adder 302-1 generates group carry and group carry transfer signals GG0 and GP0 and CLA1 adder 302-2 generates signals GG1 and GP1 and CLA1 adder 302-3 generates signals GG2 and GP2 and CLA1 adder 302-4 generates signals GG3 and GP3, respectively. Furthermore, 8 bits signal GG0 ^{~} GG3 and GP0 ^{~} GP3 from the CLA1 adder 302-1 ^{~} 302-4 are supplied with CLA1 adder 302-5. The CLA1 adder 302-5 generates the first section carry generation signal SG0 and the first section carry transfer signal SP0.

In the same manner as described above, the second to fourth section carry generation signals SG1 ^{~} SG3 and the second and fourth section carry transfer signals SP1 ^{~} SP3 are generated by the second to fourth CLA sections 300-2 300-4.

8-bit signals from the fourth CLA sections 300-1 ^{~} 300-4, that is, signals SG₀ ^{~} SG₃ and SP₀ ^{~} SP₃, are provided by the fifth CLA section 310. The fifth CLA section 310 generates first to fourth block carry signals BC₀ ^{~} BC_{3,} and their complementary signals $\overline{{\text{BC}}_{\text{0}}}$ ^{~} $\overline{{\text{BC}}_{\text{3}}}$. In addition, as described before, the fifth CLA section within the second carry generation block 160-2 generates first to third block carry signals BC₄ ^{~} BC₆, and their complementary signals $\overline{{\text{BC}}_{\text{4}}}$ ^{~} $\overline{{\text{BC}}_{\text{6}}}$.

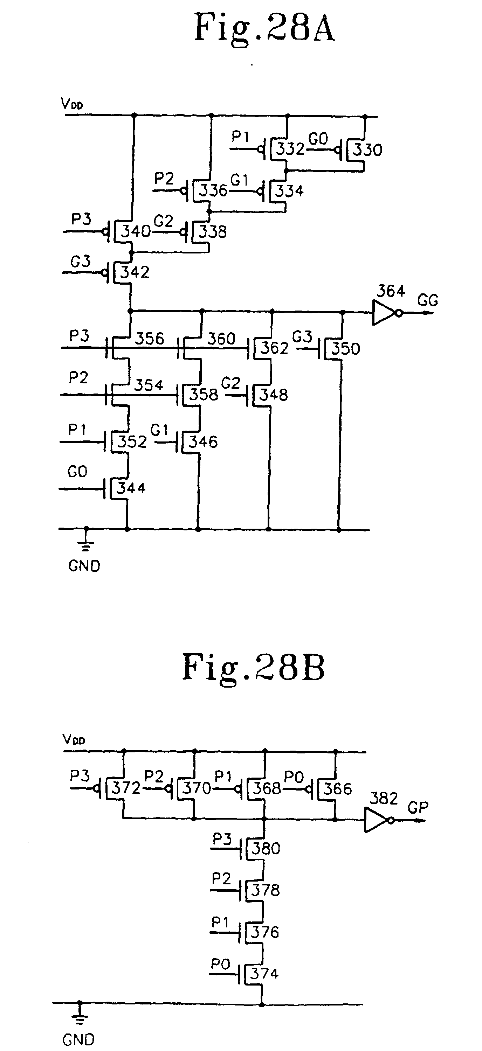

FIG. 28A and FIG. 28B are detailed circuit diagrams showing group carry generation section of each CLA1 adders and group carry propagation. Referring to FIG. 28A and FIG. 28B, the group carry generation and group carry propagation sections are consisted of the CMOS logic, by contrast with the sum generation block consisted of pass-transistor, in order to improve the operating speed of 108 bits adder. This is intended for reducing carry propagation delay caused by pass-transistor multiplexer.

As illustrated in FIG. 28A, the group carry generation of CLA1 adder includes seven PMOS transistors 330 ^{~} 342, ten NMOS transistors 344 ^{~} 362, and an invertor 364. A current path of PMOS transistor is connected between source voltage _{V.D.} and the node N331, and signal G₀ is provided to the gate thereof. Current paths of PMOS transistors 332, 336 and 340 are connected between source voltage _{V.D.} and the node N335, N339 and N341, and signals P₁ ^{~} P₃ are provided to the gate thereof.

A current path of PMOS transistor 334 is connected between the current paths of PMOS transistors 330, 332 and the node N331, and signal G₁ is provided in the gate of PMOS transistors 334. A current path of PMOS transistor 338 is connected between the current paths of PMOS transistors 334, 336 and the node N335, and signal G₂ is provided to the gate of PMOS transistor 338. A current path of PMOS transistor 342 is connected between the current paths of PMOS transistors 338, 340 and the node N341, and signal G₃ is provided to the gate of PMOS transistor 342.

Current paths of NMOS transistors 344, 352, 354 and 356 are connected in series between the ground voltage GND and the node N341, and signals G₀ and P₁ ^{~} P₃ are provided to gates of NMOS transistors 344, 352 and 354. Current paths of NMOS transistors 346, 358 and 360 are connected in series between the ground voltage GND and the node N341, and signals G₁, P₂ and P₃ are provided to gates of NMOS transistors 346, 358 and 360. Current paths of NMOS transistors 348 and 362 are connected in series between the ground voltage GND and the node N341, and signals G₂ and P₃ are provided to gate of NMOS transistors 348 and 362. A current path of NMOS transistor 350 is connected in series between the ground voltage GND and the node N341, and signals G₃ is provided to gate of NMOS transistor 350.

An invertor 364 inverts a signal generated by PMOS transistors 330 ^{~} 342 and NMOS transistors 344 ^{~} 362 on the node N341, and outputs a signal of group carry generation GG.

As illustrated in FIG. 28B, group carry propagation of CLA1 is consisted of four PMOS transistors 366 ^{~} 372, four NMOS transistors 374 - 380 and an invertor 382. Current paths of PMOS transistors 366 ^{~} 372 are connected in mutual parallel between source voltage _{V.D.} and the node N373. Current paths of NMOS transistors 374 ^{~} 380 are connected in series between the reference voltage, that is, ground voltage GND and the node N373.

An invertor 382 inverts a signal generated by PMOS transistors 366 ^{~} 372 and NMOS transistors 374 ^{~} 380 on the node N341, and outputs a signal of group carry propagation GP.

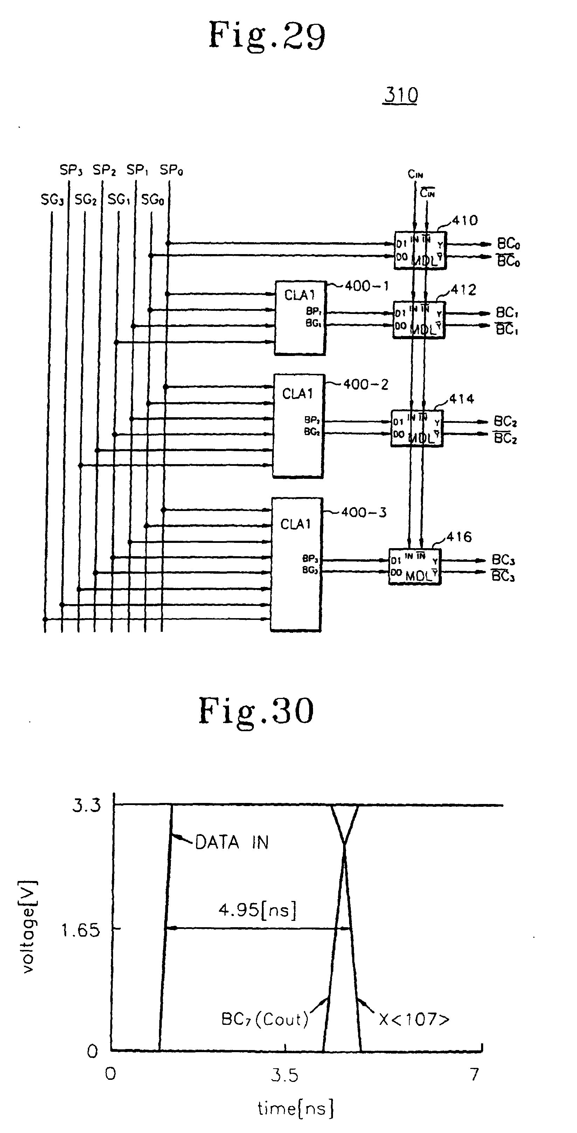

FIG. 29 is a detailed circuit diagram of CLA2 adder 310 in FIG. 27. Referring to FIG. 29, CLA2 adder 310 includes three CLA1 adders 400-1, 400-2, 400-3 and four MDLs 410, 412, 414, 416.

Each of the CLA1 adders 400-1, 400-2 and 400-3 shown in FIG. 29 has the same construction as the CLA1 of FIG. 27, and thus detailed description is omitted hereunder.

Turning again to FIG. 29, the CLA1 adder 400-1 receives SG₀, SG₁, SP₀, and SP₁ signals and produces BG₁ and BP₁ signals. The CLA1 adder 400-2 receives SG₀, SG₁, SG₂, SP₀, SP₁ and SP₂ signals and produces BG₂ and BP₂ signals. Also, the CLA1 adder 400-3 receives SG₀, SG₁, SG₂, SG₃, SP₀, SP₁, SP₂, and SP₃ signals and produces BG₃ and BP₃ signals.

The SG₀ and SP₀ signals are applied to the inputs D0 and D1 of the MDL 410, and the BG₁ and BP₁ signals from the CLA1 adder 400-1 are applied to the inputs D0 and D1 of the MSL 412. The BG₂ and BP₂ signals from the CLA1 adder 400-2 are applied to the inputs D0 and D1 of the MSL 414, and the BG₃ and BP₃ signals from the CLA1 adder 400-3 are applied to the inputs D0 and D1 of the MSL 414. Also, to the selection terminals IN and $\overline{\text{IN}}$ of each of the MDLs 410 ^{~} 416, C_{IN} and $\overline{{\text{C}}_{\text{IN}}}$ are applied.

Each MDL 410 ^{~} 416 selects and outputs any of two input signals in response to the C_{IN} and $\overline{{\text{C}}_{\text{IN}}}$ signals. The MDLs 410 ^{~} 416 produce block carry signals BC₀ ^{~} BC₃ and complementary signals $\overline{{\text{BC}}_{\text{0}}}$ ^{~} $\overline{{\text{BC}}_{\text{3}}}$ thereof, as shown in FIG. 29.

The carry generation block 160-2 has the same construction as the carry generation block 160-1 except that 12-bit carry generation signals and 12-bit carry propagation signals are provided to the fourth CLA section, and descriptions thereof are omitted.

FIG. 30 shows SPICE simulation results of the 108-bit conditional sum adder according to the present invention. From FIG. 30, it can be seen that the carry propagation is faster than the sum propagation.

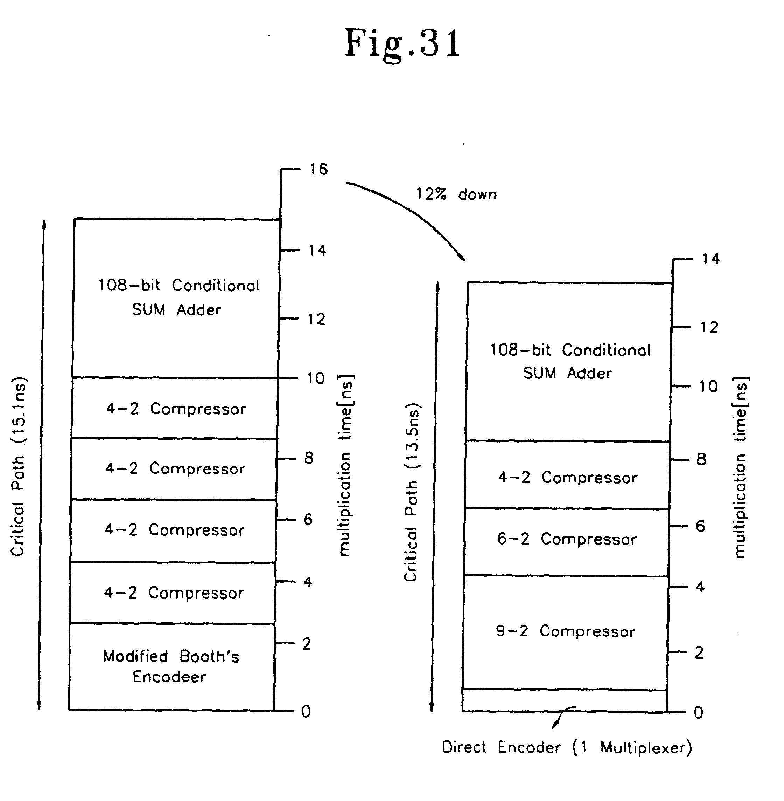

FIG. 31 shows the multiplication times between the prior art multiplier using only 4-to-2 compressors and the multiplier of FIG. 16. As shown in FIG. 31, the multiplication time with respect to threshold path of the multiplier according to the present invention is 13.5 nanoseconds, but the multiplication time of the prior art multiplier is 15.1 nanoseconds. Therefore, it can be understood from FIG. 31 that the multiplication speed of the multiplier according to the present invention is as fast as about 13% of that of the prior art multiplier.

As described above, a conditional sum adder in which EEPL circuit is implemented according to the present invention has advantages of low power dissipation, a smaller chip area.

Also, since the conditional sum adder deals with carry generation and sum generation separately, and the carry propagation is performed faster than the sum propagation, its operation speed can be improved.

## Claims

1. An N-bit conditional sum adder (118) comprising:
K M-bit sum generators (150-1 ... 150-7), wherein K is equal to the ceiling of ┌N/M┐; and
X L-bit carry generators (160-1, 160-2), wherein X is equal to the ceiling of ┌K/L┐; **characterized in that**
each of the M-bit conditional sum generators is arranged for receiving a first M-bit input signal (A) and its complementary signal $\overline{\text{(A)}}$, a second M-bit signal (B) and its complementary signal $\overline{\text{(B)}}$, a carry signal (BCᵢ) and its complementary signal $\overline{{\text{(BC}}_{\text{i}} \text{)}}$ and is adapted to generate an M-bit sum signal (S), an M-bit carry generation signal (G) and an M-bit carry propagation signal (P),
a first L-bit carry generator (160-1) is arranged to receive L M-bit carry generation signals (G) and L M-bit carry propagation signals (P) from a corresponding L M-bit conditional sum generators and is adapted to generate couples of the carry signal (BCᵢ) and carry complementary signal ($\overline{{\text{BC}}_{\text{i}}}$) to be supplied to the carry inputs of the second to the Lth of the corresponding L M-bit conditional sum generator (150-2 to 150-4) and to the next L-bit carry generators, respectively, the Lth couple of carries (BC₃,$\overline{{\text{BC}}_{\text{3}}}$) being also supplied to the carry inputs of the next higher M-bit conditional sum generator, and
each of a second to an (X ― 1) - th L-bit carry generator (160-1) is arranged to receive L M-bit carry generation signals (G) and L M-bit carry propagation signals (P) from a corresponding L M-bit conditional sum generators, and a carry signal (BCᵢ) and its complementary signal ($\overline{{\text{BC}}_{\text{i}}}$) from a preceding L-bit carry generator, and is adapted to generate couples of carry signal (BCᵢ) and carry complementary signal ($\overline{{\text{BC}}_{\text{i}}}$) to be supplied to the carry inputs of the second to the Lth of the corresponding L M-bit conditional sum generators (150-2 to 150-4) and to the next L-bit carry generator, respectively, the Lth couple of carries (BC₃, $\overline{\text{BC}}$₃) being also supplied to the carry inputs of the next higher M-bit conditional sum generator, and
the X - th L-bit carry generator (160-2) is arranged to receive the carry generation (G) and propagation (P) signals from the remaining K-Lx(X-1) M-bit conditional sum generators and a carry signal (BC₃) and its complementary signal ($\overline{{\text{BC}}_{\text{3}}}$) from the (X ― 1) - th carry generator and is adapted to generate corresponding couples of carry signal (BCᵢ) and carry complementary signal ($\overline{{\text{BC}}_{\text{i}}}$) supplied to the carry inputs of the second to the K-Lx(X-1)th of the corresponding K-Lx(X-1) M-bit conditional sum generators (150-6, 150-7), respectively, and a final a carry signal (Cₒᵤₜ) and its complementary signal ($\overline{{\text{C}}_{\text{out}}}$);
wherein each of the M-bit conditional sum generators is arranged to select for each bit a respective sum signal (S) responsive to the condition of a respective input carry signal and its complementary signal.

2. A conditional sum adder according to claim 1, wherein each of the M-bit sum generators comprises a pass-transistor logic.

3. A conditional sum adder according to claim 1 or claim 2, wherein each of the L-bit carry generators comprises a CMOS logic.

4. A conditional sum adder according any preceding claim in which M is 16 and L is four.

5. A conditional sum adder according to claim 4 in which K is 7 and X is 2.

6. A conditional sum adder according to any preceding claim wherein each of the M-bit sum generators comprises:
first means (152) for receiving the first M-bit input signal and its complementary signal and the second M-bit input signal and its complementary signal and for generating a first M-bit conditional sum signal (SH), a second M-bit conditional sum signal (SL), an M-bit carry propagation signal (CH(P)) and its complementary signal ($\overline{\text{CH}}$) and an M-bit carry generation signal (CL(G)) and its complementary signal (CL); and
second means (154) for receiving the first M-bit conditional sum signal, the second M-bit conditional sum signal, the M-bit carry propagation signal and its complementary signal, the M-bit carry generation signal and its complementary signal and the carry signal and its complementary signal for generating the M-bit sum signal (S).

7. A conditional sum adder according to claim 6 in which the first means comprises a (6xM)-bit pre-carry & sum generation block (152) and the second means an M-bit carry lookahead addition block (154).

8. A conditional sum adder according to claim 6
wherein each of the X L-bit carry generators comprises:
a group of first carry lookahead addition sections (300-1...300-4), each of which receives a corresponding M-bit carry generation signal and a corresponding M-bit carry propagation signal and generates a 1-bit section carry generation signal (SG) and a 1-bit section carry propagation signal (SP); and
a second carry lookahead addition section (310) for receiving first to L-th section carry generation signals and first to L-th section carry propagation signals from the group of first carry lookahead addition sections, and generating the L-bit carry signals and the complementary signals of the L-bit carry signals.

9. A conditional sum adder according to claim 8 in which K is 2, X is 2, M is 16 and L is 4.

10. A conditional sum adder according to claim 8 or claim 9, wherein the pre-carry & sum generation block (152) comprises:
a first logic (162) means for receiving two corresponding input signals and generating first and second sum signals;
a second logic means (164) for receiving the two corresponding input signals and generating a carry propagation signal and a complementary signal of the carry propagation signal; and
a third logic means (166) for receiving the two corresponding input signals and generating a carry generation signal and a complementary signal of the carry generation signal.

11. A conditional sum adder according to claim 10 in which the first logic means (162) comprises an XNOR logic for performing an XNOR operation of the two corresponding input signals to generate the first sum signal and an XOR logic for performing an XOR operation of the two corresponding input signals to generate the second sum signal.

12. A conditional sum adder according to claim 10 or claim 11 in which the second logic means (164) comprises an OR logic for performing an OR operation of the two corresponding input signals to generate the carry propagation signal, a NOR logic for performing a NOR operation of the two corresponding input signals to generate the complementary signal of the carry propagation signal and a first level restoration means (168) for restoring an output signal level of the NOR logic as the carry propagation signal and restoring an output signal level of the OR logic as the complementary signal of the carry propagation signal.

13. A conditional sum adder according to claim 12 in which the first level restoration means (168) comprises a first invertor having an input terminal to which the output signal of the NOR logic is applied and an output terminal generating the carry propagation signal, a second invertor having an input terminal to which the output signal of the OR logic is applied and an output terminal generating the complementary signal of the carry propagation signal, a first PMOS transistor having a current path connected between the input terminal of the first inverter and the output terminal of the second invertor and a gate connected to the input terminal of the second inverter, and a second PMOS transistor having a current path connected between the output terminal of the first invertor and the input terminal of the second invertor and a gate connected to the input terminal of the first invertor.

14. A conditional sum adder according to any one of claims 10-13 in which the third logic means (166) comprises an AND logic for performing an AND operation of the two corresponding input signals to generate the carry generation signal, a NAND logic for performing a NAND operation of the two corresponding input signals to generate the complementary signal of the carry generation signal, and a second level restoration means (170) for restoring an output signal level of the NAND logic to as the carry generation signal and restoring an output signal level of the AND logic as the complementary signal of the carry generation signal.

15. A conditional sum adder according to claim 14 in which the second level restoration means (170) comprises a third inverter having an input terminal to which the output signal of the NAND logic is applied and an output terminal generating the carry signal, a fourth inverter having an input terminal to which the output signal of the AND logic is applied and an output terminal generating the complementary signal of the carry generation signal, a third PMOS transistor having a current path connected between the input terminal of the third inverter and the output terminal of the fourth inverter and a gate connected to the input terminal of the fourth invertor, and a fourth PMOS transistor having a current path connected between the output terminal of the third invertor and the input terminal of the fourth inverter and a gate connected to the input terminal of the third invertor.

16. A conditional sum adder according to any one of claims 8-15 in which the M-bit carry lookahead addition block comprises M/2 carry lookahead addition units, each of which receives two bits of the first M-bit conditional signal, two bits of the second M-bit conditional signal, two bits of the M-bit carry propagation signal, two bits of the complementary signal of the M-bit carry propagation signal, two bits of the M-bit carry generation signal and two bits of the complementary signal of the M-bit carry generation signal, and generates a 2-bit sum signal, each of the M/2 carry lookahead addition units comprising:
a third level restoration means for receiving a 1-bit corresponding signal of two bits of the first M-bit conditional signal and a 1-bit corresponding signal of two bits of the second M-bit conditional signal so as to restore an input signal level and generate an inverse signal of the restored input signal;
first and second multiplexers for receiving output signals of the third level restoration means as input signals so as to select one or other of the input signals in response to first and second complementary control signals;
a third multiplexer for receiving output signals of the first and second multiplexers as input signals so as to select one of the input signals in response to third and fourth complementary control signals and to output an inverse signal of the selected signal as a lower-order bit sum signal;
a fourth multiplexer for receiving the other 1-bit corresponding signal of two bits of the first M-bit conditional signal and the other 1-bit corresponding signal of two bits of the second M-bit conditional signal as input signals so as to select one or other of the input signals in response to a 1-bit corresponding signal of two bits of the M-bit carry propagation signal and its complementary signal;
a fifth multiplexer for receiving the other 1-bit corresponding signal of two bits of the first M-bit conditional signal and one 1-bit corresponding signal of two bits of the second M-bit conditional signal as input signals so as to select one of the input signals in response to the other 1-bit corresponding signal of two bits of the M-bit carry propagation signal and its complementary signal;
a fourth level restoration means for receiving output signals of the fourth and fifth multiplexers so as to restore their input signal levels and generate an inverse signal of the restored input signal;
sixth and seventh multiplexers for receiving output signals of the fourth level restoration means as input signals and so as to select one or other of the input signals in response to the first and second control signals;
an eighth multiplexer for receiving output signals of the sixth and seventh multiplexers as input signals so as to select one of the input signals in response to the third and fourth control signals and generating an inverse signal of the selected signal as an upper-order bit sum signal;
a ninth multiplexer for receiving the other 1-bit corresponding signal of two bits of the M-bit carry propagation signal, its complementary signal, the other 1-bit corresponding signal of two bits of the M-bit carry generation signal and its complementary signal so as to select two signals of the input signals in response to the one 1-bit corresponding signal of two bits of the M-bit carry propagation signal and the complementary signal thereof;
a tenth multiplexer for receiving the other 1-bit corresponding signal of two bits of the M-bit carry propagation signal, the complementary signal thereof, the other 1-bit corresponding signal of two bits of the M-bit carry propagation signal, its complementary signal, the other 1-bit corresponding signal of two bits of the M-bit carry generation signal and its complementary signal so as to select two of the input signals in response to the one-bit corresponding signal of two bits of the M-bit carry propagation signal and the complementary signal thereof;
an eleventh multiplexer for receiving output signals of the ninth and tenth multiplexers as input signals so as to select two signals of the input signals in response to the first and second control signals, and generating the selected two signals as the first and second control signals of a next carry lookahead addition unit; and
a twelfth multiplexer for receiving the output signals of the ninth and tenth multiplexers as input signals so as to select two of the input signals in response to the third and fourth control signals, and generating the selected two signals as the third and fourth control signals of the next carry lookahead addition unit.

17. A conditional sum adder according to any one of claims 8-16 in which each of the first carry lookahead addition sections comprises:
first to fourth carry lookahead adders for receiving in series the corresponding 16-bit carry generation signal and the corresponding 16-bit carry propagation signal by four bits one time and generating first to fourth group carry generation signals and first to fourth group carry propagation signals; and
a fifth carry lookahead adder for receiving the first to fourth group carry generation signals and the first to fourth group carry propagation signals and generating a corresponding 1-bit section carry generation signal and a corresponding 1-bit carry propagation signal.

18. A conditional sum adder according to claim 17, wherein each of the first to fourth carry lookahead adders comprises:
means for generating a first output signal having one of two different levels in response to a corresponding 4-bit carry generation signal and a corresponding 4-bit carry propagation signal; and
means for generating a second output signal having one of the two difference levels in response to the corresponding 4-bit carry propagation signal.

19. A conditional sum adder according to claim 17 or claim 18, wherein the fifth carry lookahead adder comprises:
means for generating a third output signal having one or two different levels in response to the group carry generation signal and the corresponding group carry propagation signal; and
means for generating a fourth output signal having one of two different levels in response to the group carry propagation signal.

20. A conditional sum adder according to any one of claims 17-19, wherein each of the first to fifth carry lookahead adders comprises a CMOS pass-transistor logic.

21. A conditional sum adder according to any one of claims 8-20, wherein the second carry lookahead addition section comprises:
a first carry lookahead adder for receiving the first and second section carry generation signals and the first and second section carry propagation signals, and generating a first block carry generation signal and a first block carry propagation signal;
a second carry lookahead adder for receiving the first to third section carry generation signals and the first to third section carry propagation signals, and generating a second black carry generation signal and a second block carry propagation signal;
a third carry lookahead adder for receiving the first to fourth section carry generation signals and the first to fourth section carry propagation signals, and generating a third block carry generation signal and a third block carry propagation signal;
a first multiplexer for receiving the first section carry generation signal and the first section carry propagation signal, and a first bit signal of the 4-bit carry signal and a complementary signal of the first signal in response to on carry signal corresponding to the 4-bit carry signal and the complementary signal of the 4-bit carry signal and in response to a complementary signal of the one carry signal;
a second multiplexer for receiving the first block carry generation a second bit signal of the 4-bit carry signal and a complementary signal of the second bit signal in response to one carry signal corresponding to the 4-bit carry signal and the complementary signal of the 4-bit carry signal and in response to a complementary signal of the one carry signal;
a third multiplexer for receiving the second block carry generation signal and the second block carry propagation signal, and generating a third bit signal of the 4-bit carry signal and a complementary signal of the third bit signal in response to one carry signal corresponding to the 4-bit carry signal and the complementary signal of the 4-bit carry signal and in response to a complementary signal of the one carry signal; and
a fourth multiplexer for receiving the third block carry generation signal and the third block carry propagation signal, and generating a fourth bit signal of the 4-bit carry signal and a complementary signal of the fourth bit signal in response to one carry signal corresponding to the 4-bit carry signal and the complementary signal of the 4-bit carry signal and to a complementary signal of the one carry signal.

22. A conditional sum adder according to claim 21, wherein each of the first to third carry lookahead adders comprises:
means for generating a corresponding block carry generation signal having one of the two different levels in response to a corresponding section carry generation signal and a corresponding section carry propagation signal; and
means for generating a corresponding block carry propagation signal having one of the two different levels in response to the group carry propagation signal.

23. An integrated pass-transistor logic circuit comprising:
an encoding means (114). for receiving a first N/2-bit data signal and generating first to an (N/2)-th N/2-bit parallel data signal;
a compressing means (120) for receiving the first to (N/2)-th parallel data signals and compressing each of the parallel data signals to a 2-bit signal to generate an N/2-bit sum signal and an N/2-bit carry signal; and
an adding means (118) for the N/2-bit sum signal and the N/2-bit carry signal from the compressing means;
wherein
the encoding means generates the second N/2-bit data signal as a corresponding vertical data signal when a bit value of the first N/2-bit data signal is logic "1" and generates a vertical data signal of logic "0" when a bit value of the first N/2-bit data signal is logic "0";
and the adding means comprising an N-bit conditional sum adder according to any one of claims 1-7.

24. An integrated pass-transistor logic circuit according to claim 23 in which N is 108, K is 7, X is 2, M is 16, and L is 4.

25. An integrated pass-transistor logic circuit according to claim 24, wherein the compressing means (120) comprises fifty-four compression units for compressing each of the vertical data signals to a 1-bit sum signal and a 1-bit carry signal,
six 9-to-2 compressors, each of which compresses a 9-bit data signal provided from the encoding means to a 2-bit data signal;
two 6-to-2 compressors, each of which compresses a 6-bit data signal provided from the six 9-to-2 compressors to a 2-bit data signal; and
a 4-to-2 compressor which compresses a 4-bit data signal provided from the two 6-to-2 compressors to a 2-bit data signal.

26. The integrated pass transistor logic circuit according to claim 25, wherein each of the 9-to-2 compressors receives the 9-bit data signal provided from the encoding means (114) and the 6-bit data signal provided from a corresponding 9-to-2 compressor of a pre-stage compression unit, and generates a first carry bit signal, a sum bit signal and a second carry bit signal to be provided to a corresponding 9-to-2 compressor of a next stage compression unit.

27. The integrated pass transistor logic circuit according to claim 25 or claim 26, wherein each of the 6-to-2 compressors receives the 6-bit data signal provided from the 9-to-2 compressors and a 3-bit data signal provided from a corresponding 6-to-2 compressor of the pre-stage compression unit, and generates a first carry bit signal, the sum bit signal and a second carry bit signal to be provided to a corresponding 6-to-2 compressor of a next stage compression unit.

28. The integrated pass transistor logic circuit according to any one of claims 25-27, wherein the 4-to-2 compressor receives a 4-bit vertical signal provided from the 6-to-2 compressors and a 1-bit carry signal from the 4-to-2 compressor of the pre-stage compression unit and generates the first carry bit signal, the sum bit signal and the second carry bit signal to be provided to a corresponding 4-to-2 compressor of a next stage compression unit.

29. The integrated pass transistor logic circuit according to any one of claims 25-28, wherein each of the 9-to-2 compressors comprises:
first to third full-adders (122,124,126), each of which receives by three bits the 9-bit data signal from the encoding means and generates first to third sum bit signals (S₁ S₂, S₃) and first to third carry bit signals to be provided to a corresponding 9-to-2 compressor of the next stage compression unit;
a fourth full-adder (128) for receiving the first to third sum bit signals and generating a fourth sum bit signal and a fourth carry bit signal to be provided to the corresponding 9-to-2 compressor of the next stage compression unit;
a fifth full-adder (130) for receiving the first to third carry bit signals from the pre-stage compression unit and generating a fifth sum bit signal and a fifth carry bit signal to be provided to the corresponding 9-to-2 compressor of the next stage compression unit;
a sixth full-adder (132) for receiving the fourth to fifth sum bit signals and the fourth carry bit signal and generating a sixth sum bit signal and a sixth carry bit signal to be provided to the corresponding 9-to-2 compressor of the next stage compression unit; and
a seventh full-adder (134) for receiving the sixth sum bit signal and the fifth and sixth carry bit signals and generating final sum (SUM) and carry bit (CARRY) signals.

30. The integrated pass transistor logic circuit according to any one of claims 25-29, wherein each of the 6-to-2 compressors comprises:
eighth (136) and ninth (138) full-adders for receiving three bits data signal from three corresponding 9-to-2 compressors and generating the first and second sum bit signals and the first and second carry bit signals to be provided to the corresponding 6-to-2 compressor of the next stage-compression unit;
a tenth full-adder (140) for receiving the first to third bit signals provided from the 6-to-2 compressor of the pre-stage compression unit and generating the third sum bit signal and the third carry bit signal to be provided to the corresponding 6-to-2 compressor of the next stage compression unit; and
an eleventh full-adder (142) for receiving the first to third sum bit signals and generating the final sum and carry bit signals.

31. The integrated pass transistor logic circuit according to any one of claims 25-30, wherein each of the 4-to-2 compressors comprises:
a twelfth full-adder (144) for receiving a lower-order 3-bit signal of a 4-bit vertical data signal provided from the 6-to-2 compressors and generating the first sum bit signals and the carry bit signals to be provided to the corresponding 4-to-2 compressor of the next stage compression unit; and
a thirteenth full-adder (146) for receiving a most significant bit of the 4-bit vertical data signal, the first sum bit signal and the carry signal provided from the 4-to-2 compressor of the pre-stage compression unit and generating the final sum and carry bit signals.

32. The integrated pass transistor logic circuit according to any one of claims 29 to 31, wherein each of the full-adders comprises:
first to fourth output terminals for generating the carry signal, a complementary signal of the carry signal, the sum signal and a complementary signal of the sum signal;
a first inverter having an input terminal connected to the second output terminal and an output terminal for generating the carry signal;
a second invertor having an input terminal connected to the third output terminal and an output terminal for generating the sum signal;
a first PMOS transistor having a current path connected between the input terminal of the first inverter and the output terminal of the second inverter, and a gate connected to the input terminal of the second invertor; and
a second PMOS transistor having a current path connected between the output terminal of the first invertor and the input terminal of the second invertor, and a gate connected to the input terminal of the first invertor.

## Patentansprüche

1. Bedingter N-Bit-Addierer (118), der Folgendes umfasst:
K M-Bit-Summengeneratoren (150-1 ... 150-7), wobei K gleich der Aufrundungszahl von ϕN/Mκ ist; und
X L-Bit-Übertragsgeneratoren (160-1, 160-2), wobei X gleich der Aufrundungszahl von ϕK/Lκ ist, **dadurch gekennzeichnet, dass**
jeder der bedingten M-Bit-Summengeneratoren die Aufgabe hat, ein erstes M-Bit-Eingangssignal (A) und sein Komplementärsignal ($\overline{\text{A}}$), ein zweites M-Bit-Signal (B) und sein Komplementärsignal ($\overline{\text{B}}$), ein Übertragssignal (BCᵢ) und sein Komplementärsignal ($\overline{{\text{BC}}_{\text{i}}}$) zu empfangen und die Aufgabe hat, ein M-Bit-Summensignal (S), ein M-Bit-Übertragserzeugungssignal (G) und ein M-Bit-Übertragsfortpflanzungssignal (P) zu erzeugen,
ein erster L-Bit-Übertragsgenerator (160-1) so gestaltet ist, dass er L M-Bit-Übertragserzeugungssignale (G) und L M-Bit-Übertragsfortpflanzungssignale (P) von entsprechenden bedingten L M-Bit-Summengeneratoren empfängt und so gestaltet ist, dass er Paare des Übertragssignals (BCᵢ) und Übertragskomplementärsignals ($\overline{{\text{BC}}_{\text{i}}}$) erzeugt, die an die Übertragseingänge des zweiten bis L-ten der entsprechenden bedingten L M-Bit-Summengeneratoren (150-2 bis 150-4) bzw. an die nächsten L-Bit-Übertragsgeneratoren anzulegen sind, wobei das L-te Paar von Übertragssignalen (BC₃, $\overline{{\text{BC}}_{\text{3}}}$) ebenfalls an die Übertragseingänge zum nächsthöheren bedingten M-Bit-Summengenerator angelegt wird, und
jeder aus einem zweiten bis (X - 1)-ten L-Bit-Übertragsgenerator (160-1) die Aufgabe hat, M-Bit-Übertragserzeugungssignale (G) und M-Bit-Übertragsfortpflanzungssignale (P) von entsprechenden bedingten L M-Bit-Summengeneratoren sowie ein Übertragssignal (BCᵢ) und sein Komplementärsignal ($\overline{{\text{BC}}_{\text{i}}}$) von einem vorherigen L-Bit-Übertragsgenerator zu empfangen, und so gestaltet ist, dass er Paare von Übertragssignal (BCᵢ) und Übertragskomplementärsignal ($\overline{{\text{BC}}_{\text{i}}}$) erzeugt, die an die Übertragseingänge des zweiten bis L-ten der entsprechenden bedingten L M-Bit-Summengeneratoren (150-2 bis 150-4) bzw. an die nächsten L-Bit-Übertragsgeneratoren anzulegen sind, wobei das L-te Paar von Übertragssignalen (BC₃, $\overline{{\text{BC}}_{\text{3}}}$) ebenfalls an die Übertragseingänge zum nächsthöheren bedingten M-Bit-Summengenerator angelegt wird, und
der X-te L-Bit-Übertragsgenerator (160-2) so gestaltet ist, dass er die Übertragserzeugungs- (G) und Fortpflanzungssignale (P) von den übrigen bedingten K-Lx(X - 1) M-Bit-Summengeneratoren und ein Übertragssignal (BC₃) und sein Komplementärsignal ($\overline{{\text{BC}}_{\text{3}}}$) vom (X - 1)-ten Übertragsgenerator empfängt und die Aufgabe hat, entsprechende Paare von Übertragssignal (BCᵢ) und Übertragskomplementärsignal ($\overline{{\text{BC}}_{\text{i}}}$), die jeweils an die Übertragseingänge des zweiten bis K-Lx(X - 1)-ten der entsprechenden bedingten K-Lx(X - 1) M-Bit-Summengeneratoren (150-6, 150-7) angelegt werden, und schließlich ein Übertragssignal (Cₒᵤₜ) und sein Komplementärsignal ($\overline{{\text{C}}_{\text{out}}}$) zu erzeugen;
wobei jeder der bedingten M-Bit-Summengeneratoren die Aufgabe hat, für jedes Bit ein jeweiliges Summensignal (S) zu selektieren, das auf den Zustand eines jeweiligen Eingangsübertragssignals und seines Komplementärsignals anspricht.

2. Bedingter Addierer nach Anspruch 1, wobei jeder der M-Bit-Summengeneratoren eine Durchlasstransistorlogik umfasst.

3. Bedingter Addierer nach Anspruch 1 oder Anspruch 2, wobei jeder der L-Bit-Übertragsgeneratoren eine CMOS-Logik umfasst.

4. Bedingter Addierer nach einem der vorherigen Ansprüche, wobei M gleich 16 und L gleich vier ist.

5. Bedingter Addierer nach Anspruch 4, wobei K gleich 7 und X gleich 2 ist.

6. Bedingter Addierer nach einem der vorherigen Ansprüche, wobei jeder der M-Bit-Summengeneratoren Folgendes umfasst:
ein erstes Mittel (152) zum Empfangen des ersten M-Bit-Eingangssignals und seines Komplementärsignals sowie des zweiten M-Bit-Eingangssignals und seines Komplementärsignals und zum Erzeugen eines ersten bedingten M-Bit-Summensignals (SH), eines zweiten bedingten M-Bit-Summensignals (SL), eines M-Bit-Übertragsfortpflanzungssignals (CH(P)) und seines Komplementärsignals ($\overline{\text{CH}}$) und eines M-Bit-Übertragserzeugungssignals (CL(G)) und seines Komplementärsignals ($\overline{\text{CL}}$); und
ein zweites Mittel (154) zum Empfangen des ersten bedingten M-Bit-Summensignals und des zweiten bedingten M-Bit-Summensignals, des M-Bit-Übertragsfortpflanzungssignals und seines Komplementärsignals, des M-Bit-Übertragserzeugungssignals und seines Komplementärsignals sowie des Übertragssignals und seines Komplementärsignals zum Erzeugen des M-Bit-Summensignals (S).

7. Bedingter Addierer nach Anspruch 6, bei dem das erste Mittel einen (6xM)-Bit-Vorübertrags- & -Summenerzeugungsblock (152) und das zweite Mittel einen M-Bit-Übertragsvorgriffsadditionsblock (154) umfasst.

8. Bedingter Addierer nach Anspruch 6, wobei jeder der X L-Bit-Übertragsgeneratoren Folgendes umfasst:
eine Gruppe von ersten Übertragsvorgriffsadditionssektionen (300-1 ... 300-4), von denen jede ein entsprechendes M-Bit-Übertragserzeugungssignal und ein entsprechendes M-Bit-Übertragsfortpflanzungssignal empfängt und ein 1-Bit-Sektionsübertragserzeugungssignal (SG) und ein 1-Bit-Sektionsübertragsfortpflanzungssignal (SP) erzeugt; und
eine zweite Übertragsvorgriffsadditionssektion (310) zum Empfangen der ersten bis L-ten Sektionsübertragserzeugungssignale und der ersten bis L-ten Sektionsübertragsfortpflanzungssignale aus der Gruppe der ersten Übertragsvorgriffsadditionssektionen und zum Erzeugen der L-Bit-Übertragssignale und der Komplementärsignale der L-Bit-Übertragssignale.

9. Bedingter Addierer nach Anspruch 8, bei dem K gleich 2, X gleich 2, M gleich 16 und L gleich 4 ist.

10. Bedingter Addierer nach Anspruch 8 oder Anspruch 9, bei dem der Vorübertrags- & Summenerzeugungsblock (152) Folgendes umfasst:
ein erstes Logikmittel (162) zum Empfangen von zwei entsprechenden Eingangssignalen und zum Erzeugen eines ersten und zweiten Summensignals;
ein zweites Logikmittel (164) zum Empfangen der beiden entsprechenden Eingangssignale und zum Erzeugen eines Übertragsfortpflanzungssignals und eines Komplementärsignals des Übertragsfortpflanzungssignals; und
ein drittes Logikmittel (166) zum Empfangen der beiden entsprechenden Eingangssignale und zum Erzeugen eines Übertragserzeugungssignals und eines Komplementärsignals des Übertragserzeugungssignals.

11. Bedingter Addierer nach Anspruch 10, bei dem das erste Logikmittel (162) eine XNOR-Logik zum Ausführen einer XNOR-Operation der beiden entsprechenden Eingangssignale zum Erzeugen des ersten Summensignals und eine XOR-Logik zum Ausführen einer XOR-Operation der beiden entsprechenden Eingangssignale zum Erzeugen des zweiten Summensignals umfasst.

12. Bedingter Addierer nach Anspruch 10 oder Anspruch 11, bei dem das zweite Logikmittel (164) eine OR-Logik zum Ausführen einer OR-Operation der beiden entsprechenden Eingangssignale zum Erzeugen des Übertragsfortpflanzungssignals, eine NOR-Logik zum Ausführen einer NOR-Operation der beiden entsprechenden Eingangssignale zum Erzeugen des Komplementärsignals des Übertragsfortpflanzungssignals und ein erstes Pegelwiederherstellungsmittel (168) zum Wiederherstellen eines Ausgangssignalpegels der NOR-Logik als das Übertragsfortpflanzungssignal und zum Wiederherstellen eines Ausgangssignalpegels der OR-Logik als das Komplementärsignal des Übertragsfortpflanzungssignals umfasst.

13. Bedingter Addierer nach Anspruch 12, bei dem das erste Pegelwiederherstellungsmittel (168) Folgendes umfasst:
einen ersten Wechselrichter mit einem Eingangsanschluss, an den das Ausgangssignal der NOR-Logik angelegt wird, und einen Ausgangsanschluss zum Erzeugen des Übertragsfortpflanzungssignals, einen zweiten Wechselrichter mit einem Eingangsanschluss, an den das Ausgangssignal der OR-Logik angelegt wird, und einem Ausgangsanschluss zum Erzeugen des Komplementärsignals des Übertragsfortpflanzungssignals, einen ersten PMOS-Transistor mit einem Strompfad, der zwischen dem Eingangsanschluss des ersten Wechselrichters und dem Ausgangsanschluss des zweiten Wechselrichters geschaltet ist, und einem Gatter, das mit dem Eingangsanschluss des zweiten Wechselrichters verbunden ist, und einen zweiten PMOS-Transistor mit einem Strompfad, der zwischen dem Ausgangsanschluss des ersten Wechselrichters und dem Eingangsanschluss des zweiten Wechselrichters geschaltet ist, und einem Gatter, das mit dem Eingangsanschluss des ersten Wechselrichters verbunden ist.

14. Bedingter Addierer nach einem der Ansprüche 10-13, bei dem das dritte Logikmittel (166) eine AND-Logik zum Ausführen einer AND-Operation der beiden entsprechenden Eingangssignale zum Erzeugen des Übertragserzeugungssignals, eine NAND-Logik zum Ausführen einer NAND-Operation der beiden entsprechenden Eingangssignale zum Erzeugen des Komplementärsignals des Übertragserzeugungssignals und ein zweites Pegelwiederherstellungsmittel (170) zum Wiederherstellen eines Ausgangssignalpegels der NAND-Logik als das Übertragserzeugungssignal und zum Wiederherstellen eines Ausgangssignalpegels der AND-Logik als das Komplementärsignal des Übertragserzeugungssignals umfasst.

15. Bedingter Addierer nach Anspruch 14, bei dem das zweite Pegelwiederherstellungsmittel (170) Folgendes umfasst: einen dritten Wechselrichter mit einem Eingangsanschluss, an den das Ausgangssignal der NAND-Logik angelegt wird, und einem Ausgangsanschluss zum Erzeugen des Übertragssignals, einen vierten Wechselrichter mit einem Eingangsanschluss, an den das Ausgangssignal der AND-Logik angelegt wird, und einem Ausgangsanschluss zum Erzeugen des Komplementärsignals des Übertragserzeugungssignals, einen dritten PMOS-Transistor mit einem Strompfad, der zwischen dem Eingangsanschluss des dritten Wechselrichters und dem Ausgangsanschluss des vierten Wechselrichters geschaltet ist, und einem Gatter, das mit dem Eingangsanschluss des vierten Wechselrichters verbunden ist, und einen vierten PMOS-Transistor mit einem Strompfad, der zwischen dem Ausgangsanschluss des dritten Wechselrichters und dem Eingangsanschluss des vierten Wechselrichters geschaltet ist, und einem Gatter, das mit dem Eingangsanschluss des dritten Wechselrichters verbunden ist.

16. Bedingter Addierer nach einem der Ansprüche 8-15, bei dem der M-Bit-Übertragsvorgriffsadditionsblock M/2 Übertragsvorgriffsadditionseinheiten umfasst, die jeweils zwei Bits des ersten bedingten M-Bit-Signals, zwei Bits des zweiten bedingten M-Bit-Signals, zwei Bits des M-Bit-Übertragsfortpflanzungssignals, zwei Bits des Komplementärsignals des M-Bit-Übertragsfortpflanzungssignals, zwei Bits des M-Bit-Übertragserzeugungssignals und zwei Bits des Komplementärsignals des M-Bit-Übertragserzeugungssignals empfangen und ein 2-Bit-Summensignal erzeugt, wobei jede der M/2 Übertragsvorgriffsadditionseinheiten Folgendes umfasst:
ein drittes Pegelwiederherstellungsmittel zum Empfangen eines entsprechenden 1-Bit-Signals von zwei Bits des ersten bedingten M-Bit-Signals und ein entsprechendes 1-Bit-Signal von zwei Bits des zweiten bedingten M-Bit-Signals, um einen Eingangssignalpegel wiederherzustellen und ein Umkehrsignal des wiederhergestellten Eingangssignals zu erzeugen;
einen ersten und einen zweiten Multiplexer zum Empfangen von Ausgangssignalen des dritten Pegelwiederherstellungsmittels als Eingangssignale, um das eine oder das andere der Eingangssignale als Reaktion auf das erste und das zweite Komplementärsteuersignal zu selektieren;
einen dritten Multiplexer zum Empfangen von Ausgangssignalen des ersten und des zweiten Multiplexers als Eingangssignale, um eines der Eingangssignale als Reaktion auf ein drittes und ein viertes Komplementärsteuersignal zu selektieren und ein Umkehrsignal des gewählten Signals als untergeordnetes Bitsummensignal auszugeben;
einen vierten Multiplexer zum Empfangen des anderen entsprechenden 1-Bit-Signals von zwei Bits des ersten bedingten M-Bit-Signals und des anderen entsprechenden 1-Bit-Signals von zwei Bits des zweiten bedingten M-Bit-Signals als Eingangssignale, um das eine oder das andere der Eingangssignale als Reaktion auf ein entsprechendes 1-Bit-Signal von zwei Bits des M-Bit-Übertragsfortpflanzungssignals und seines Komplementärsignals zu selektieren;
einen fünften Multiplexer zum Empfangen des anderen entsprechenden 1-Bit-Signals von zwei Bits des ersten bedingten M-Bit-Signals und von einem entsprechenden 1-Bit-Signal von zwei Bits des zweiten bedingten M-Bit-Signals als Eingangssignale, um eines der Eingangssignale als Reaktion auf das andere entsprechende 1-Bit-Signal von zwei Bits des M-Bit-Übertragsfortpflanzungssignals und seines Komplementärsignals zu selektieren;
ein viertes Pegelwiederherstellungsmittel zum Empfangen von Ausgangssignalen des vierten und des fünften Multiplexers, um deren Eingangssignalpegel wiederherzustellen und ein Umkehrsignal des wiederhergestellten Eingangssignals zu erzeugen;
einen sechsten und einen siebten Multiplexer zum Empfangen von Ausgangssignalen des vierten Pegelwiederherstellungsmittels als Eingangssignale und um das eine oder das andere der Eingangssignale als Reaktion auf das erste und zweite Steuersignal zu selektieren;
einen achten Multiplexer zum Empfangen von Ausgangssignalen des sechsten und des siebten Multiplexers als Eingangssignale, um eines der Eingangssignale als Reaktion auf das dritte und das vierte Steuersignal zu selektieren und ein Umkehrsignal des gewählten Signals als übergeordnetes Bitsummensignal zu erzeugen;
einen neunten Multiplexer zum Empfangen des anderen entsprechenden 1-Bit-Signals von zwei Bits des M-Bit-Übertragsfortpflanzungssignals, seines Komplementärsignals, des anderen entsprechenden 1-Bit-Signals von zwei Bits des M-Bit-Übertragserzeugungssignals und seines Komplementärsignals, um zwei Signale der Eingangssignale als Reaktion auf das eine entsprechende 1-Bit-Signal von zwei Bits des M-Bit-Übertragsfortpflanzungssignals und des Komplementärsignals davon zu selektieren;
einen zehnten Multiplexer zum Empfangen des anderen entsprechenden 1-Bit-Signals von zwei Bits des M-Bit-Übertragsfortpflanzungssignals, des Komplementärsignals davon, des anderen entsprechenden 1-Bit-Signals von zwei Bits des M-Bit-Übertragsfortpflanzungssignals, seines Komplementärsignals, des anderen entsprechenden 1-Bit-Signals von zwei Bits des M-Bit-Übertragserzeugungssignals und seines Komplementärsignals, um zwei der Eingangssignale als Reaktion auf das entsprechende 1-Bit-Signal von zwei Bits des M-Bit-Übertragsfortpflanzungssignals und des Komplementärsignals davon zu selektieren;
einen elften Multiplexer zum Empfangen von Ausgangssignalen des neunten und des zehnten Multiplexers als Eingangssignale, um zwei Signale der Eingangssignale als Reaktion auf das erste und das zweite Steuersignal zu selektieren und die selektierten zwei Signale als das erste und das zweite Steuersignal einer nächsten Übertragsvorgriffsadditionseinheit zu erzeugen; und
einen zwölften Multiplexer zum Empfangen der Ausgangssignale des neunten und zehnten Multiplexers als Eingangssignale, um zwei der Eingangssignale als Reaktion auf das dritte und das vierte Steuersignal zu selektieren und die selektierten beiden Signale als drittes und viertes Steuersignal der nächsten Übertragsvorgriffsadditionseinheit zu erzeugen.

17. Bedingter Addierer nach einem der Ansprüche 8-16, wobei die ersten Übertragsvorgriffsadditionssektionen Folgendes umfassen:
einen ersten bis vierten Übertragsvorgriffsaddierer, um in Reihe das entsprechende 16-Bit-Übertragserzeugungssignal und das entsprechende 16-Bit-Übertragsfortpflanzungssignal mit jeweils vier Bits zu empfangen und die ersten bis vierten Gruppenübertragserzeugungssignale und ersten bis vierten Gruppenübertragsfortpflanzungssignale zu erzeugen; und
einen fünften Übertragsvorgriffsaddierer zum Empfangen der ersten bis vierten Gruppenübertragserzeugungssignale und der ersten bis vierten Gruppenübertragsfortpflanzungssignale und zum Erzeugen eines entsprechenden 1-Bit-Sektionsübertragserzeugungssignals und eines entsprechenden 1-Bit-Übertragsfortpflanzungssignals.

18. Bedingter Addierer nach Anspruch 17, wobei jeder der ersten bis vierten Übertragsvorgriffsaddierer Folgendes umfasst:
Mittel zum Erzeugen eines ersten Ausgangssignals mit einem von zwei verschiedenen Pegeln als Reaktion auf ein entsprechendes 4-Bit-Übertragserzeugungssignal und ein entsprechendes 4-Bit-Übertragsfortpflanzungssignal; und
Mittel zum Erzeugen eines zweiten Ausgangssignals mit einem der beiden Differenzpegel als Reaktion auf das entsprechende 4-Bit-Übertragsfortpflanzungssignal.

19. Bedingter Addierer nach Anspruch 17 oder Anspruch 18, wobei der erste Übertragsvorgriffsaddierer Folgendes umfasst:
Mittel zum Erzeugen eines dritten Ausgangssignals mit einem oder zwei verschiedenen Pegeln als Reaktion auf das Gruppenübertragserzeugungssignal und das entsprechende Gruppenübertragsfortpflanzungssignal; und
Mittel zum Erzeugen eines vierten Ausgangssignals mit einem von zwei verschiedenen Pegeln als Reaktion auf das Gruppenübertragsfortpflanzungssignal.

20. Bedingter Addierer nach einem der Ansprüche 17-19, wobei jeder der ersten bis fünften Übertragsvorgriffsaddierer eine CMOS-Durchlasstransistorlogik umfasst.

21. Bedingter Addierer nach einem der Ansprüche 8-20, wobei die zweite Übertragsvorgriffsadditionssektion Folgendes umfasst:
einen ersten Übertragsvorgriffsaddierer zum Empfangen des ersten und zweiten Sektionsübertragserzeugungssignals und des ersten und zweiten Sektionsübertragsfortpflanzungssignals und zum Erzeugen eines ersten Blockübertragserzeugungssignals und eines ersten Blockübertragsfortpflanzungssignals;
einen zweiten Übertragsvorgriffsaddierer zum Empfangen der ersten bis dritten Sektionsübertragserzeugungssignale und der ersten bis dritten Sektionsübertragsfortpflanzungssignale und zum Erzeugen eines zweiten schwarzen Übertragserzeugungssignals [*1] und eines zweiten Blockübertragsfortpflanzungssignals;
einen dritten Übertragsvorgriffsaddierer zum Empfangen der ersten bis vierten Sektionsübertragserzeugungssignale und der ersten bis vierten Sektionsübertragsfortpflanzungssignale und zum Erzeugen eines dritten Blockübertragserzeugungssignals und eines dritten Blockübertragsfortpflanzungssignals;
einen ersten Multiplexer zum Empfangen des ersten Sektionsübertragserzeugungssignals und des ersten Sektionsübertragsfortpflanzungssignals und eines ersten Bitsignals des 4-Bit-Übertragssignals und eines Komplementärsignals des ersten Signals als Reaktion darauf, dass ein Übertragssignal dem 4-Bit-Übertragssignal und dem Komplementärsignal des 4-Bit-Übertragssignals entspricht, und als Reaktion auf ein Komplementärsignal des einen Übertragssignals;
einen zweiten Multiplexer zum Empfangen der ersten Blockübertragserzeugungssignals, [*2] eines zweiten Bitsignals des 4-Bit-Übertragssignals und eines Komplementärsignals des zweiten Bitsignals als Reaktion darauf, dass ein Übertragssignal dem 4-Bit-Übertragssignal und dem Komplementärsignal des 4-Bit-Übertragssignals entspricht, und als Reaktion auf ein Komplementärsignal des einen Übertragssignals;
einen dritten Multiplexer zum Empfangen des zweiten Blockübertragserzeugungssignals und des zweiten Blockübertragsfortpflanzungssignals und zum Erzeugen eines dritten Bitsignals des 4-Bit-Übertragssignals und eines Komplementärsignals des dritten Bitsignals als Reaktion darauf, dass ein Übertragssignal dem 4-Bit-Übertragssignal und dem Komplementärsignal des 4-Bit-Übertragssignals entspricht und als Reaktion auf ein Komplementärsignal des einen Übertragssignals; und
einen vierten Multiplexer zum Empfangen des dritten Blockübertragserzeugungssignals und des dritten Blockübertragsfortpflanzungssignals und zum Erzeugen eines vierten Bitsignals des 4-Bit-Übertragssignals und eines Komplementärsignals des vierten Bitsignals als Reaktion darauf, dass ein Übertragssignal dem 4-Bit-Übertragssignal und dem Komplementärsignal des 4-Bit-Übertragssignals und einem Komplementärsignal des einen Übertragssignals entspricht.

22. Bedingter Addierer nach Anspruch 21, bei dem jeder der ersten bis dritten Übertragsvorgriffsaddierer Folgendes umfasst:
Mittel zum Erzeugen eines entsprechenden Blockübertragserzeugungssignals mit einem der beiden verschiedenen Pegel als Reaktion auf ein entsprechendes Sektionsübertragserzeugungssignal und ein entsprechendes Sektionsübertragsfortpflanzungssignal; und
Mittel zum Erzeugen eines entsprechenden Blockübertragsfortpflanzungssignals mit einem der beiden verschiedenen Pegel als Reaktion auf das Gruppenübertragsfortpflanzungssignal.

23. Integrierte Durchlasstransistor-Logikschaltung, die Folgendes umfasst:
ein Codiermittel (114) zum Empfangen eines ersten N/2-Bit-Datensignals und zum Erzeugen eines ersten bis (N/2)-ten parallelen N/2-Bit-Datensignals;
ein Komprimiermittel (120) zum Empfangen des ersten bis (N/2)-ten parallelen Datensignals und zum Komprimieren jedes der parallelen Datensignale in ein 2-Bit-Signal zum Erzeugen eines N/2-Bit-Summensignals und eines N/2-Bit-Übertragssignals; und
ein Addiermittel (118) für das N/2-Bit-Summensignal und das N/2-Bit-Übertragssignal von dem Komprimiermittel; wobei
das Codiermittel das zweite N/2-Bit-Datensignal als entsprechendes vertikales Datensignal erzeugt, wenn ein Bitwert des ersten N/2-Bit-Datensignals logisch "1" ist, und ein vertikales Datensignal mit logisch "0" erzeugt, wenn ein Bitwert des ersten N/2-Bit-Datensignals logisch "0" ist;
und das Addiermittel einen bedingten N-Bit-Summenaddierer nach einem der Ansprüche 1-7 umfasst.

24. Integrierte Durchlasstransistor-Logikschaltung nach Anspruch 23, bei der N gleich 108, K gleich 7, X gleich 2, M gleich 16 und L gleich 4 ist.

25. Integrierte Durchlasstransistor-Logikschaltung nach Anspruch 24, bei der das Komprimiermittel (120) vierundfünfzig Komprimiereinheiten zum Komprimieren der einzelnen vertikalen Datensignale in ein 1-Bit-Summensignal und ein 1-Bit-Übertragssignal umfasst,
sechs 9-auf-2-Kompressoren, die jeweils ein 9-Bit-Datensignal vom Codiermittel in ein 2-Bit-Datensignal komprimieren;
zwei 6-auf-2-Kompressoren, die jeweils ein 6-Bit-Datensignal von den sechs 9-auf-2-Kompressoren in ein 2-Bit-Datensignal komprimieren; und
einen 4-auf-2-Kompressor, der ein 4-Bit-Datensignal von den beiden 6-auf-2-Kompressoren in ein 2-Bit-Datensignal komprimiert.

26. Integrierte Durchlasstransistor-Logikschaltung nach Anspruch 25, bei der jeder der 9-auf-2-Kompressoren das 9-Bit-Datensignal von dem Codiermittel (114) und das 6-Bit-Datensignal von einem entsprechenden 9-auf-2-Kompressor einer vorherigen Komprimiereinheit empfängt und ein erstes Übertragsbitsignal, ein Summenbitsignal und ein zweites Übertragsbitsignal erzeugt, die an einen entsprechenden 9-auf-2-Kompressor einer Komprimiereinheit einer nächsten Stufe anzulegen sind.

27. Integrierte Durchlasstransistor-Logikschaltung nach Anspruch 25 oder Anspruch 26, bei der jeder der 6-auf-2-Kompressoren das 6-Bit-Datensignal von den 9-auf-2-Kompressoren und ein 3-Bit-Datensignal von einem entsprechenden 6-auf-2-Kompressor der vorherigen Komprimiereinheit empfängt und ein erstes Übertragsbitsignal, das Summenbitsignal und ein zweites Übertragsbitsignal erzeugt, die an einen entsprechenden 6-auf-2-Kompressor einer Komprimiereinheit einer nächsten Stufe anzulegen sind.

28. Integrierte Durchlasstransistor-Logikschaltung nach einem der Ansprüche 25-27, wobei der 4-auf-2-Kompressor ein vertikales 4-Bit-Signal von den 6-auf-2-Kompressoren und ein 1-Bit-Übertragssignal von dem 4-auf-2-Kompressor der vorherigen Komprimiereinheit empfängt und das erste Übertragsbitsignal, das Summenbitsignal und das zweite Übertragsbitsignal erzeugt, die an einen entsprechenden 4-auf-2-Kompressor einer Komprimiereinheit einer nächsten Stufe anzulegen sind.

29. Integrierte Durchlasstransistor-Logikschaltung nach einem der Ansprüche 25-28, wobei jeder der 9-auf-2-Kompressoren Folgendes umfasst:
erste bis dritte Volladdierer (122, 124, 126), die jeweils drei Bits des 9-Bit-Datensignals von dem Codiermittel empfangen und erste bis dritte Summenbitsignale (S₁, S₂, S₃) und erste bis dritte Übertragsbitsignale erzeugen, die an einen entsprechenden 9-auf-2-Kompressor der nächsten Komprimiereinheit anzulegen sind;
einen vierten Volladdierer (128) zum Empfangen der ersten bis dritten Summenbitsignale und zum Erzeugen eines vierten Summenbitsignals und eines vierten Übertragsbitsignals, die an den entsprechenden 9-auf-2-Kompressor der nächsten Komprimiereinheit anzulegen sind;
einen fünften Volladdierer (130) zum Empfangen der ersten bis dritten Übertragsbitsignale von der vorherigen Komprimiereinheit und zum Erzeugen eines fünften Summenbitsignals und eines fünften Übertragsbitsignals, die an den entsprechenden 9-auf-2-Kompressor der nächsten Komprimiereinheit anzulegen sind;
einen sechsten Volladdierer (132) zum Empfangen der vierten bis fünften Summenbitsignale und des vierten Übertragsbitsignals und zum Erzeugen eines sechsten Summenbitsignals und eines sechsten Übertragsbitsignals, die an den entsprechenden 9-auf-2-Kompressor der nächsten Komprimiereinheit anzulegen sind; und
einen siebten Volladdierer (134) zum Empfangen des sechsten Summenbitsignals und der fünften und sechsten Übertragsbitsignale und zum Erzeugen der letzten Summen- (SUM) und Übertragsbit- (CARRY) Signale.

30. Integrierte Durchlasstransistor-Logikschaltung nach einem der Ansprüche 25-29, wobei jeder der 6-auf-2-Kompressoren Folgendes umfasst:
einen achten (136) und einen neunten (138) Volladdierer zum Empfangen von drei Bit Datensignal von drei entsprechenden 9-auf-2-Kompressoren und zum Erzeugen der ersten und zweiten Summenbitsignale und der ersten und zweiten Übertragsbitsignale, die an den entsprechenden 6-auf-2-Kompressor der nächsten Komprimiereinheit anzulegen sind;
einen zehnten Volladdierer (140) zum Empfangen der ersten bis dritten Bitsignale vom 6-auf-2-Kompressor der vorherigen Komprimiereinheit und zum Erzeugen des dritten Summenbitsignals und des dritten Übertragsbitsignals, die an den entsprechenden 6-auf-2-Kompressor der nächsten Komprimiereinheit anzulegen sind; und
einen elften Volladdierer (142) zum Empfangen der ersten bis dritten Summenbitsignale und zum Erzeugen der letzten Summen- und Übertragsbitsignale.

31. Integrierte Durchlasstransistor-Logikschaltung nach einem der Ansprüche 25-30, wobei jeder der 4-auf-2-Kompressoren Folgendes umfasst:
einen zwölften Volladdierer (144) zum Empfangen eines untergeordneten 3-Bit-Signals eines vertikalen 4-Bit-Datensignals von den 6-auf-2-Kompressoren und zum Erzeugen der ersten Summenbitsignale und der Übertragsbitsignale, die an den entsprechenden 4-auf-2-Kompressor der nächsten Komprimiereinheit anzulegen sind; und
einen dreizehnten Volladdierer (146) zum Empfangen eines höchstwertigen Bits des vertikalen 4-Bit-Datensignals, des ersten Summenbitsignals und des Übertragssignals von dem 4-auf-2-Kompressor der vorherigen Komprimiereinheit und zum Erzeugen der letzten Summen- und Übertragsbitsignale.

32. Integrierte Durchlasstransistor-Logikschaltung nach einem der Ansprüche 29 bis 31, wobei jeder der Volladdierer Folgendes umfasst:
erste bis vierte Ausgangsanschlüsse zum Erzeugen des Übertragssignals, eines Komplementärsignals des Übertragssignals, des Summensignals und eines Komplementärsignals des Summensignals;
einen ersten Wechselrichter mit einem Eingangsanschluss, der mit dem zweiten Ausgangsanschluss und einem Ausgangsanschluss zum Erzeugen des Übertragssignals verbunden ist;
einen zweiten Wechselrichter mit einem Eingangsanschluss, der mit dem dritten Ausgangsanschluss und einem Ausgangsanschluss zum Erzeugen des Summensignals verbunden ist;
einen ersten PMOS-Transistor mit einem Strompfad, der zwischen dem Eingangsanschluss des ersten Wechselrichters und dem Ausgangsanschluss des zweiten Wechselrichters geschaltet ist, und einem Gatter, das mit dem Eingangsanschluss des zweiten Wechselrichters verbunden ist; und
einen zweiten PMOS-Transistor mit einem Strompfad, der zwischen dem Ausgangsanschluss des ersten Wechselrichters und dem Eingangsanschluss des zweiten Wechselrichters geschaltet ist, und einem Gatter, das mit dem Eingangsanschluss des ersten Wechselrichters verbunden ist.

## Revendications

1. Additionneur de sommes conditionnelles à N bits (118) comprenant :
K générateurs de sommes à M bits (150-1 ... 150-7), où K est égal au plafond de [N/M] ; et
X générateurs de reports à L bits (160-1, 160-2), où X est égal au plafond de [K/L] ; **caractérisés en ce que**
chacun des générateurs de sommes conditionnelles à M bits est disposé de façon à recevoir un premier signal d'entrée à M bits (A) et son signal complémentaire (A), un second signal à M bits (B) et son signal complémentaire (B), un signal de report (BCᵢ) et son signal complémentaire (BCᵢ), et est adapté pour produire un signal de somme à M bits (S), un signal de génération de report à M bits (G) et un signal de propagation de report à M bits (P),
un premier générateur de reports à L bits (160-1) est disposé de façon à recevoir L signaux de génération de reports à M bits (G) et L signaux de propagation de reports à M bits (P) provenant de L générateurs de sommes conditionnelles à M bits correspondants, et est adapté pour produire L paires de signal de report (BCᵢ) et de signal complémentaire de report (BCᵢ) à fournir aux entrées de reports du deuxième au L^{ième} des L générateurs de sommes conditionnelles à M bits correspondants (150-2 à 150-4) et aux générateurs de reports à L bits suivants, respectivement, la L^{ième} paire de reports (BC₃, BC₃) étant également fournie aux entrées de reports du générateur de sommes conditionnelles à M bits plus élevé suivant, et
chacun d'un deuxième à un (X - 1)^{ième} générateur de reports à L bits (160-1) est disposé de façon à recevoir L signaux de génération de reports à M bits (G) et L signaux de propagation de reports à M bits (P) provenant de L générateurs de sommes conditionnelles à M bits correspondants, et un signal de report (BCᵢ) et son signal complémentaire (BCᵢ) provenant d'un générateur de reports à L bits précédent, et est adapté pour produire L paires de signal de report (BCᵢ) et de signal de report complémentaire (BCᵢ) à fournir aux entrées de reports du deuxième au L^{ième} des L générateurs de sommes conditionnelles à M bits correspondants (150-2 à 150-4) et au générateur de reports à L bits suivant, respectivement, la L^{ième} paire de reports (BC₃, BC₃) étant également fournie aux entrées de reports du générateur de sommes conditionnelles à M bits plus élevé suivant, et
le X^{ième} générateur de reports à L bits (160-2) est disposé de façon à recevoir les signaux de génération (G) et de propagation (P) de reports provenant des K-Lx(X - 1) générateurs de sommes conditionnelles à M bits restants et un signal de report (BC₃) et son signal complémentaire (BC₃) provenant du (X - 1)^{ième} générateur de reports, et est adapté pour produire les paires correspondantes de signal de report (BC₁) et de signal complémentaire de report (BC₁) fournies aux entrées de reports du deuxième au K-Lx(X-1)^{ième} des K-Lx(X-1) générateurs de sommes conditionnelles à M bits correspondants (150-6, 150-7), respectivement, et un signal de report final (Cₒᵤₜ) et son signal complémentaire (Cₒᵤₜ) ;
dans lequel chacun des générateurs de sommes conditionnelles à M bits est disposé de façon à sélectionner pour chaque bit un signal de somme respectif (S) sensible à l'état d'un signal de report d'entrée respectif et de son signal complémentaire.

2. Additionneur de sommes conditionnelles selon la revendication 1, dans lequel chacun des générateurs de sommes à M bits comprend une logique à transistors ballasts.

3. Additionneur de sommes conditionnelles selon la revendication 1 ou la revendication 2, dans lequel chacun des générateurs de reports à L bits comprend une logique CMOS.

4. Additionneur de sommes conditionnelles selon l'une quelconque des revendications précédentes, dans lequel M est 16 et L est 4.

5. Additionneur de sommes conditionnelles selon la revendication 4 dans lequel K est 7 et X est 2.

6. Additionneur de sommes conditionnelles selon l'une quelconque des revendications précédentes dans lequel chacun des générateurs de sommes à M bits comprend :
un premier moyen (152) pour recevoir le premier signal d'entrée à M bits et son signal complémentaire et le deuxième signal d'entrée à M bits et son signal complémentaire et pour produire un premier signal de somme conditionnelle à M bits (SH), un deuxième signal de somme conditionnelle à M bits (SL), un signal de propagation de report à M bits (CH(P)) et son signal complémentaire (CH) et un signal de génération de report à M bits (CL(G)) et son signal complémentaire (CL) ; et
un deuxième moyen (154) pour recevoir le premier signal de somme conditionnelle à M bits, le deuxième signal de somme conditionnelle à M bits, le signal de propagation de report à M bits et son signal complémentaire, le signal de génération de report à M bits et son signal complémentaire et le signal de report et son signal complémentaire pour produire le signal de somme à M bits (S).

7. Additionneur de sommes conditionnelles selon la revendication 6 dans lequel le premier moyen comprend un bloc de génération de pré-reports et de sommes à (6xM) bits (152) et le deuxième moyen comprend un bloc d'addition anticipée de report à M bits (154).

8. Additionneur de sommes conditionnelles selon la revendication 6
dans lequel chacun des X générateurs de reports à L bits comprend :
un groupe de premières sections d'addition anticipée de report (300-1 ... 300-4), dont chacune reçoit un signal de génération de report à M bits correspondant et un signal de propagation de report à M bits correspondant et produit un signal de génération de report de section à 1 bit (SG) et un signal de propagation de report de section à 1 bit (SP) ; et
une deuxième section d'addition anticipée de report (310) pour recevoir le premier au L^{ième} des signaux de génération de reports de section et le premier au L^{ième} des signaux de propagation de reports de section provenant du groupe des premières sections d'addition anticipée de reports, et pour produire les signaux de reports à L bits et les signaux complémentaires des signaux de reports à L bits.

9. Additionneur de sommes conditionnelles selon la revendication 8 dans lequel K est 2, X est 2, M est 16 et L est 4.

10. Additionneur de sommes conditionnelles selon la revendication 8 ou la revendication 9, dans lequel le bloc de génération de pré-reports et de sommes (152) comprend :
un premier moyen logique (162) pour recevoir deux signaux d'entrée correspondants et produire le premier et deuxième signal de somme ;
un deuxième moyen logique (164) pour recevoir les deux signaux d'entrée correspondants et produire un signal de propagation de report et un signal complémentaire du signal de propagation de report ; et
un troisième moyen logique (166) pour recevoir les deux signaux d'entrée correspondants et produire un signal de génération de report et un signal complémentaire du signal de génération de report.

11. Additionneur de sommes conditionnelles selon la revendication 10 dans lequel le premier moyen logique (162) comprend une logique XNOR pour effectuer une opération XNOR des deux signaux d'entrée correspondants afin de produire le premier signal de somme et une logique XNOR pour effectuer une opération XNOR des deux signaux d'entrée correspondants afin de produire le deuxième signal de somme.

12. Additionneur de sommes conditionnelles selon la revendication 10 ou la revendication 11 dans lequel le deuxième moyen logique (164) comprend une logique OR pour effectuer une opération OR des deux signaux d'entrée correspondants afin de produire le signal de propagation de report, une logique NOR pour effectuer une opération NOR des deux signaux d'entrée correspondants afin de produire le signal complémentaire du signal de propagation de report et un premier moyen de rétablissement de niveau (168) pour rétablir un niveau du signal de sortie de la logique NOR comme le signal de propagation de report et pour rétablir un niveau du signal de sortie de la logique OR comme le signal complémentaire du signal de propagation de report.

13. Additionneur de sommes conditionnelles selon la revendication 12 dans lequel le premier moyen de rétablissement de niveau (168) comprend un premier inverseur ayant une borne d'entrée sur laquelle est appliqué le signal de sortie de la logique NOR et une borne de sortie produisant le signal de propagation de report, un deuxième inverseur ayant une borne d'entrée sur laquelle est appliqué le signal de sortie de la logique OR et une borne de sortie produisant le signal complémentaire du signal de propagation de report, un premier transistor MOS à canal P ayant un chemin de courant connecté entre la borne d'entrée du premier inverseur et la borne de sortie du deuxième inverseur et une porte connectée à la borne d'entrée du deuxième inverseur, et un deuxième transistor MOS à canal P ayant un chemin de courant connecté entre la borne de sortie du premier inverseur et la borne d'entrée du deuxième inverseur et une porte connectée à la borne d'entrée du premier inverseur.

14. Additionneur de sommes conditionnelles selon l'une quelconque des revendications 10 à 13 dans lequel le troisième moyen logique (166) comprend une logique AND pour effectuer une opération AND des deux signaux d'entrée correspondants afin de produire un signal de génération de report, une logique NAND pour effectuer une opération NAND des deux signaux d'entrée correspondants afin de produire le signal complémentaire du signal de génération de report, et un deuxième moyen de rétablissement de niveau (170) pour rétablir un niveau de signal de sortie de la logique NAND comme le signal de génération de report et pour rétablir un niveau de signal de sortie de la logique AND comme le signal complémentaire du signal de génération de report.

15. Additionneur de sommes conditionnelles selon la revendication 14 dans lequel le deuxième moyen de rétablissement de niveau (170) comprend un troisième inverseur ayant une borne de sortie sur laquelle est appliqué le signal de sortie de la logique NAND et une borne de sortie produisant le signal de report, un quatrième inverseur ayant une borne d'entrée sur laquelle est appliqué le signal de sortie de la logique AND et une borne de sortie produisant le signal complémentaire du signal de génération de report, un troisième transistor MOS à canal P ayant un chemin de courant connecté entre la borne d'entrée du troisième inverseur et la borne de sortie du quatrième inverseur et une porte connectée à la borne d'entrée du quatrième inverseur, et un quatrième transistor MOS à canal P ayant un chemin de courant connecté entre la borne de sortie du troisième inverseur et la borne d'entrée du quatrième inverseur et une porte connectée à la borne d'entrée du troisième inverseur.

16. Additionneur de sommes conditionnelles selon l'une quelconque des revendications 8-15 dans lequel le bloc d'addition anticipée de report à M bits comprend M/2 unités d'addition anticipée de report, dont chacune reçoit deux bits du premier signal conditionnel à M bits, deux bits du deuxième signal conditionnel à M bits, deux bits du signal de propagation de report à M bits, deux bits du signal complémentaire du signal de propagation de report à M bits, deux bits du signal de génération de report à M bits et deux bits du signal complémentaire du signal de génération de report à M bits, et produit un signal de somme à 2 bits, chacune des M/2 unités d'addition anticipée de report comprenant :
un troisième moyen de rétablissement de niveau pour recevoir un signal à 1 bit correspondant à deux bits du premier signal conditionnel à M bits et un signal à 1 bit correspondant à deux bits du deuxième signal conditionnel à M bits afin de rétablir un niveau de signal d'entrée et de produire un signal inverse au signal d'entrée rétabli ;
un premier et un deuxième multiplexeur pour recevoir des signaux de sortie du troisième moyen de rétablissement de niveau comme signaux d'entrée afin de sélectionner un signal ou un autre des signaux d'entrée en réponse au premier et au deuxième signal de commande complémentaire ;
un troisième multiplexeur pour recevoir les signaux de sortie du premier et du deuxième multiplexeur comme signaux d'entrée afin de sélectionner un des signaux d'entrée en réponse au troisième et au quatrième signal de commande complémentaire et de fournir un signal inverse au signal sélectionné comme signal de somme à bit de rang inférieur ;
un quatrième multiplexeur pour recevoir l'autre signal à 1 bit correspondant à deux bits du premier signal conditionnel à M bits et l'autre signal à 1 bit correspondant à deux bits du deuxième signal conditionnel à M bits comme signaux d'entrée afin de sélectionner un signal ou un autre des signaux d'entrée en réponse à un signal à 1 bit correspondant à deux bits du signal de propagation de report à M bits et à son signal complémentaire ;
un cinquième multiplexeur pour recevoir l'autre signal à 1 bit correspondant à deux bits du premier signal conditionnel à M bits et un signal unique à 1 bit correspondant à deux bits du deuxième signal conditionnel à M bits comme signaux d'entrée afin de sélectionner un des signaux d'entrée en réponse à l'autre signal à 1 bit correspondant à deux bits du signal de propagation de report à M bits et à son signal complémentaire ;
un quatrième moyen de rétablissement de niveau pour recevoir les signaux de sortie du quatrième et du cinquième multiplexeur afin de rétablir les niveaux de leurs signaux d'entrée et de produire un signal inverse au signal d'entrée rétabli ;
un sixième et un septième multiplexeur pour recevoir les signaux de sortie du quatrième moyen de rétablissement de niveau comme signaux d'entrée et afin de sélectionner un signal ou un autre des signaux d'entrée en réponse au premier et au deuxième signal de commande ;
un huitième multiplexeur pour recevoir les signaux de sortie du sixième et du septième multiplexeur comme signaux d'entrée afin de sélectionner un des signaux d'entrée en réponse au troisième et au quatrième . signal de commande et pour produire un signal inverse au signal sélectionné comme un signal de somme à bit de rang supérieur ;
un neuvième multiplexeur pour recevoir l'autre signal à 1 bit correspondant à deux bits du signal de propagation de report à M bits, son signal complémentaire, l'autre signal à 1 bit correspondant à deux bits du signal du signal de génération de report à M bits et son signal complémentaire afin de sélectionner deux des signaux d'entrée en réponse à un signal à 1 bit correspondant à deux bits du signal de propagation de report à M bits et au signal complémentaire de ce dernier ;
un dixième multiplexeur pour recevoir l'autre signal à 1 bit correspondant à deux bits du signal de propagation de report à M bits, le signal complémentaire de celui-ci, l'autre signal à 1 bit correspondant à deux bits du signal de propagation de report à M bits, son signal complémentaire, l'autre signal à 1 bit correspondant à deux bits du signal de génération de report à M bits et son signal complémentaire afin de sélectionner deux des signaux d'entrée en réponse au signal à un bit correspondant à deux bits du signal de propagation de report à M bits et au signal complémentaire de ce dernier ;
un onzième multiplexeur pour recevoir des signaux de sortie du neuvième et du dixième multiplexeur comme signaux d'entrée afin de sélectionner deux des signaux d'entrée en réponse au premier et au deuxième signal de commande, et pour produire les deux signaux sélectionnés comme le premier et le deuxième signal de commande d'une unité d'addition anticipée de report suivante ; et
un douzième multiplexeur pour recevoir les signaux de sortie du neuvième et du dixième multiplexeur comme signaux d'entrée afin de sélectionner deux des signaux d'entrée en réponse au troisième et au quatrième signal de commande, et pour produire les deux signaux sélectionnés comme le troisième et le quatrième signal de commande de l'unité d'addition anticipée de report suivante.

17. Additionneur de sommes conditionnelles selon l'une quelconque des revendications 8 à 16 dans lequel chacune des premières sections d'addition anticipée de report comprend :
un premier à quatrième additionneur d'anticipation de report pour recevoir en série le signal de génération de report à 16 bits correspondant et le signal de propagation de report à 16 bits correspondant par quatre bits une fois et pour produire le premier au quatrième signal de génération de report de groupe et le premier au quatrième signal de propagation de report de groupe ; et
un cinquième additionneur d'anticipation de report pour recevoir le premier au quatrième signal de génération de report de groupe et le premier au quatrième signal de propagation de report de groupe et pour produire un signal de génération de report de section à 1 bit correspondant et un signal de propagation de report à 1 bit correspondant.

18. Additionneur de sommes conditionnelles selon la revendication 17, dans lequel chacun du premier au quatrième additionneur d'anticipation de report comprend :
un moyen pour produire un premier signal de sortie ayant un de deux niveaux différents en réponse à un signal de génération de report à 4 bits correspondant et à un signal de propagation de report à 4 bits correspondant ; et
un moyen pour produire un deuxième signal de sortie ayant un des deux niveaux différents en réponse au signal de propagation de report à 4 bits correspondant.

19. Additionneur de sommes conditionnelles selon la revendication 17 ou la revendication 18, dans lequel le cinquième additionneur d'anticipation de report comprend :
un moyen pour produire un troisième signal de sortie ayant un de deux niveaux différents en réponse au signal de génération de report de groupe correspondant et au signal de propagation de report de groupe correspondant ; et
un moyen pour produire un quatrième signal de sortie ayant un de deux niveaux différents en réponse au signal de propagation de report de groupe.

20. Additionneur de sommes conditionnelles selon l'une quelconque des revendications 17 à 19, dans lequel chacun du premier au cinquième additionneur d'anticipation de report comprend une logique CMOS à transistors ballasts.

21. Additionneur de sommes conditionnelles selon l'une quelconque des revendications 8 à 20, dans lequel la deuxième section d'addition anticipée de report comprend :
un premier additionneur d'anticipation de report pour recevoir le premier et le deuxième signal de génération de report de section et le premier et le deuxième signal de propagation de report de section, et pour produire un premier signal de génération de report de bloc et un premier signal de propagation de report de bloc ;
un deuxième additionneur d'anticipation de report pour recevoir le premier au troisième signal de génération de report de section et le premier au troisième signal de propagation de report de section, et pour produire un deuxième signal de génération de report de bloc et un deuxième signal de propagation de report de bloc ;
un troisième additionneur d'anticipation de report pour recevoir le premier au quatrième signal de génération de report de section et le premier au quatrième signal de propagation de report de section, et pour produire un troisième signal de génération de report de bloc et un troisième signal de propagation de report de bloc ;
un premier multiplexeur pour recevoir le premier signal de génération de report de section et le premier signal de propagation de report de section, et un premier signal binaire du signal de report à 4 bits et un signal complémentaire du premier signal binaire en réponse à un signal unique de report correspondant au signal de report à 4 bits et au signal complémentaire du signal de report à 4 bits et en réponse à un signal complémentaire du signal unique de report ;
un deuxième multiplexeur pour recevoir le premier signal de génération de report de bloc un deuxième signal binaire du signal de report à 4 bits et un signal complémentaire du deuxième signal binaire en réponse à un signal unique de report correspondant au signal de report à 4 bits et au signal complémentaire du signal de report à 4 bits et en réponse à un signal complémentaire du signal unique de report ;
un troisième multiplexeur pour recevoir le deuxième signal de génération de report de bloc et le deuxième signal de propagation de report de bloc, et pour produire un troisième signal binaire du signal de report à 4 bits et un signal complémentaire du troisième signal binaire en réponse à un signal unique de report correspondant au signal de report à 4 bits et au signal complémentaire du signal de report à 4 bits et en réponse à un signal complémentaire du signal unique de report ; et
un quatrième multiplexeur pour recevoir le troisième signal de génération de report de bloc et le troisième signal de propagation de report de bloc, et pour produire un quatrième signal binaire du signal de report à 4 bits et un signal complémentaire du quatrième signal binaire en réponse à un signal unique de report correspondant au signal de report à 4 bits et au signal complémentaire du signal de report à 4 bits et en réponse à un signal complémentaire du signal unique de report .

22. Additionneur de sommes conditionnelles selon la revendication 21, dans lequel chacun du premier au quatrième additionneur d'anticipation de report comprend :
un moyen pour produire un signal de génération de report de bloc correspondant ayant un des deux niveaux différents en réponse à un signal de génération de report de section correspondant et à un signal de propagation de report de section correspondant ; et
un moyen pour produire un signal de propagation de report de bloc correspondant ayant un des deux niveaux différents en réponse au signal de propagation de report de groupe.

23. Circuit logique intégré à transistors ballasts comprenant :
un moyen de codage (114) pour recevoir un premier signal de données à N/2 bits et pour produire le premier au (N/2)^{ième} des signaux de données parallèles à N/2 bits ;
un moyen de compression (120) pour recevoir le premier au (N/2) ^{ième} des signaux de données parallèles et pour comprimer chacun des signaux de données parallèles en un signal à 2 bits afin de produire un signal de somme à N/2 bits et un signal de report à N/2 bits ; et
un moyen d'addition (118) pour le signal de somme à N/2 bits et le signal de report à N/2 bits provenant du moyen de compression ; dans lequel le moyen de codage produit le deuxième signal de données à N/2 bits comme un signal de données vertical correspondant lorsqu'une valeur binaire du premier signal de données à N/2 bits est "1" logique et produit un signal de données vertical à l'état logique "0" lorsqu'une valeur binaire du premier signal de données à N/2 bits est à l'état logique "0" ; et ce moyen d'addition comprenant un additionneur de sommes conditionnelles à N bits selon l'une quelconque des revendications 1 à 7.

24. Circuit logique intégré à transistors ballasts selon la revendication 23 dans lequel N est 108, K est 7, X est 2, M est 16 et L est 4.

25. Circuit logique intégré à transistors ballasts selon la revendication 24, dans lequel le moyen de compression (120) comprend cinquante-quatre unités de compression pour comprimer chacun des signaux de données verticaux en un signal de somme à 1 bit et un signal de report à 1 bit,
six compresseurs de 9 à 2, dont chacun comprime un signal de données à 9 bits fourni par le moyen de codage en un signal de données à 2 bits ;
deux compresseurs de 6 à 2, dont chacun comprime un signal de données à 6 bits fourni par les compresseurs de 9 à 2 en un signal de données à 2 bits ; et
un compresseur de 4 à 2 qui comprime un signal de données à 4 bits fourni par les compresseurs de 6 à 2 en un signal de données à 2 bits.

26. Le circuit logique intégré à transistors ballasts selon la revendication 25, dans lequel chacun des compresseurs de 9 à 2 reçoit le signal de données à 9 bits fourni par le moyen de codage (114) et le signal de données à 6 bits fourni par un compresseur de 9 à 2 correspondant de l'unité de compression précédente, et produit un premier signal binaire de report, un signal binaire de somme et un deuxième signal binaire de report à fournir à un compresseur de 9 à 2 correspondant d'une unité de compression suivante.

27. Le circuit logique intégré à transistors ballasts selon la revendication 25 ou la revendication 26, dans lequel chacun des compresseurs de 6 à 2 reçoit le signal de données à 6 bits fourni par les compresseurs de 9 à 2 et un signal de données à 3 bits fourni par un compresseur de 6 à 2 correspondant de l'unité de compression précédente, et produit un premier signal binaire de report, le signal binaire de somme et un deuxième signal binaire de report à fournir à un compresseur de 6 à 2 correspondant d'une unité de compression suivante.

28. Le circuit logique intégré à transistors ballasts selon l'une quelconque des revendications 25 à 27, dans lequel le compresseur de 4 à 2 reçoit un signal vertical à 4 bits fourni par les compresseurs de 6 à 2 et un signal de report à 1 bit fourni par le compresseur de 4 à 2 de l'unité de compression précédente et produit le premier signal binaire de report, le signal binaire de somme et le deuxième signal binaire de report à fournir à un compresseur de 4 à 2 correspondant d'une unité de compression suivante.

29. Le circuit logique intégré à transistors ballasts selon l'un quelconque des revendications 25 à 28, dans lequel chacun des compresseurs de 9 à 2 comprend :
un premier à un troisième additionneur complet (122, 124, 126), dont chacun reçoit par trois bits le signal de données à 9 bits provenant du moyen de codage et produit le premier au troisième signal binaire de somme (S₁ S₂ S₃) et le premier au troisième signal binaire de report à fournir à un compresseur de 9 à 2 correspondant de l'unité de compression suivante ;
un quatrième additionneur complet (128) pour recevoir le premier au troisième signal binaire de somme et pour produire un quatrième signal binaire de somme et un quatrième signal binaire de report à fournir au compresseur de 9 à 2 correspondant de l'unité de compression suivante ;
un cinquième additionneur complet (130) pour recevoir le premier au troisième signal binaire de report provenant de l'unité de compression précédente et pour produire un cinquième signal binaire de somme et un cinquième signal binaire de report à fournir au compresseur de 9 à 2 correspondant de l'unité de compression suivante ;
un sixième additionneur complet (132) pour recevoir le quatrième au cinquième signal binaire de somme et le quatrième signal binaire de report et pour produire un sixième signal binaire de somme et un sixième signal binaire de report à fournir au compresseur de 9 à 2 correspondant de l'unité de compression suivante ; et
un septième additionneur complet (134) pour recevoir le sixième signal binaire de somme et le cinquième et le sixième signal binaire de report et produire des signaux binaires finals de somme (SUM) et de report (CARRY).

30. Le circuit logique intégré à transistors ballasts selon l'une quelconque des revendications 25 à 29, dans lequel chacun des compresseurs de 6 à 2 comprend :
un huitième (136) et un neuvième (138) additionneur complet pour recevoir un signal de données à 3 bits provenant des trois compresseurs de 9 à 2 correspondants et pour produire le premier et le deuxième signal binaire de somme et le premier et le deuxième signal binaire de report à fournir au compresseur de 6 à 2 correspondant de l'unité de compression suivante ;
un dixième additionneur complet (140) pour recevoir le premier au troisième signal binaire fourni par le compresseur de 6 à 2 de l'unité de compression suivante et pour produire le troisième signal binaire de somme et le troisième signal binaire de report à fournir au compresseur de 6 à 2 correspondant de l'unité de compression suivante ; et
un onzième additionneur complet (142) pour recevoir le premier au troisième signal binaire de somme et pour produire les signaux binaires finals de somme et de report.

31. Le circuit logique intégré à transistors ballasts selon l'une quelconque des revendications 25 à 30, dans lequel chacun des compresseurs de 4 à 2 comprend :
un douzième additionneur complet (144) pour recevoir un signal à 3 bits de rang inférieur d'un signal de données vertical à 4 bits fourni par les compresseurs de 6 à 2 et pour produire les premiers signaux binaires de somme et les signaux binaires de report à fournir au compresseur de 4 à 2 correspondant de l'unité de compression suivante ; et
un treizième additionneur complet (146) pour recevoir un bit de poids fort du signal de données vertical à 4 bits, le premier signal binaire de somme et le signal de report fournis par le compresseur de 4 à 2 de l'unité de compression précédente et pour produire les signaux binaires finals de somme et de report.

32. Le circuit logique intégré à transistors ballasts selon l'une quelconque des revendications 29 à 31, dans lequel chacun des additionneurs complets comprend :
une première à quatrième borne de sortie pour produire le signal de report, un signal complémentaire du signal de report, le signal de somme et un signal complémentaire du signal de somme ;
un premier inverseur ayant une borne d'entrée connectée à la deuxième borne de sortie et une borne de sortie pour produire le signal de report ;
un deuxième inverseur ayant une borne d'entrée connectée à la troisième borne de sortie et une borne de sortie pour produire le signal de somme ;
un premier transistor MOS à canal P ayant un chemin de courant connecté entre la borne d'entrée du premier inverseur et la borne de sortie du deuxième inverseur, et une porte connectée à la borne d'entrée du deuxième inverseur ; et
un deuxième transistor MOS à canal P ayant un chemin de courant connecté entre la borne de sortie du premier inverseur et la borne d'entrée du deuxième inverseur, et une porte connectée à la borne d'entrée du premier inverseur.
